# EUROPEAN PATENT APPLICATION

(11) **EP 3 893 092 A2**
(43) Date of publication of application: **13.10.2021**
(21) Application number: 21170286.5
(22) Date of filing: 22.09.2017
(51) Int. Cl.: G06F 3/01, C09K 5/06, H01L 35/32, H01L 35/04

(54) **FLEXIBLE THERMOELECTRIC MODULE AND THERMOELECTRIC APPARATUS COMPRISING SAME**

(30) Priority: 31.10.2016 US 201662415437 P; 19.05.2017 KR 20170062597; 19.05.2017 KR 20170062599; 19.05.2017 KR 20170062600; 31.08.2017 KR 20170111463; 31.08.2017 KR 20170111466
(62) Divisional of application: 17863485.3
(71) Applicant: Tegway Co., Ltd., Daejeon 34051 (KR)
(72) Inventor: YI, Kyoung Soo, Daejeon 34207 (KR); NOH, Jin Seong, Yuseong-gu, Daejeon 34176 (KR)
(74) Representative: D Young & Co LLP

(57) **Abstract**

The present invention relates to a flexible thermoelectric module and, more specifically, to a flexible thermoelectric module used in the shape of a curved surface. A flexible thermoelectric module used in the shape of a curved surface according to the present invention includes a substrate provided in a plate shape transformable into the shape of a curved surface, a plurality of thermoelectric elements comprising an N-type semiconductor and a P-type semiconductor disposed so as to form a two-dimensional array on the substrate, and a plurality of electrodes connecting the N-type semiconductor and P-type semiconductor, wherein the plurality of thermoelectric elements form a thermoelectric line comprising thermoelectric elements consecutively connected by means of the electrodes and forming a line, wherein an extension direction of the thermoelectric line can be closer to a direction perpendicular to a curving direction for transformation into the shape of a curved surface than the curving direction.

## Description

### [Technical Field]

The present invention relates to a flexible thermoelectric module, and more particularly, to a flexible thermoelectric module used in a curved shape.

### [Background Art]

A thermoelectric element (TE) is an element that causes heat energy to be exchanged with electrical energy using a thermoelectric effect such as the Seeback effect or the Peltier effect. In recent years, studies on body-temperature power generation and cooling technology using such thermoelectric elements have been actively conducted. However, since conventional thermoelectric elements are mostly manufactured on a ceramic substrate, they can be used only in the form of a flat plate and have limited application fields.

In recent years, development of flexible thermoelectric elements (FTEs) has become successful, and it is expected that the FTEs can overcome the problems of the conventional thermoelectric elements and effectively provide thermal feedback to users.

### [Disclosure]

### [Technical Problem]

The present invention is directed to providing a flexible thermoelectric module with improved flexibility.

The present invention is also directed to providing a flexible thermoelectric module with improved durability.

The present invention is also directed to providing a flexible thermoelectric module deformable into a complex curved shape.

The present invention is also directed to providing a thermoelectric apparatus with improved waste heat release performance and improved cold sensation provision performance.

It will be appreciated by persons skilled in the art that the objects that could be achieved with the present invention are not limited to what has been particularly described hereinabove and other objects not mentioned above will be clearly understood by those skilled in the art from the present specification and the accompanying drawings.

### [Technical Solution]

According to an aspect of the present invention, a flexible thermoelectric module used in a curved shape, the module may comprise a substrate provided in a plate shape deformable into a curved shape; a plurality of thermoelectric elements including an N-type semiconductor and a P-type semiconductor arranged to form a two-dimensional array on the substrate; and a plurality of electrodes connecting the N-type semiconductor and the P-type semiconductor, wherein the plurality of thermoelectric elements are sequentially connected by the electrodes and forms a thermoelectric line including the thermoelectric elements forming a line shape, and wherein an extending direction of the thermoelectric line is closer to a direction perpendicular to a curving direction than the curving direction for being deformed into the curved shape.

According to another aspect of the present invention, a flexible thermoelectric module used in a curved shape may comprise a substrate provided in a plate shape deformable into a curved shape; a plurality of thermoelectric elements including an N-type semiconductor and a P-type semiconductor arranged to form a two-dimensional array on the substrate; a first electrode connecting the N-type semiconductor and the P-type semiconductor along a first direction; and a second electrode connecting the N-type semiconductor and the P-type semiconductor along a second direction perpendicular to the first direction, wherein a curving direction for being deformed into the curved shape coincides with a direction along which one of the first electrode and the second electrode that is smaller in number connects the N-type semiconductor and the P-type semiconductor.

According to still another aspect of the present invention, a flexible thermoelectric module used in a curved shape, the module may comprise: a substrate provided in a plate shape deformable into a curved shape; a plurality of thermoelectric elements including an N-type semiconductor and a P-type semiconductor arranged to form a two-dimensional array on the substrate; a first electrode connecting the thermoelectric element sequentially along a first direction to form a thermoelectric line; and a second electrode connecting the thermoelectric element along a second direction perpendicular to the first direction to form an electrical connection between the thermoelectric line, wherein the second direction is closer to a curving direction for being deformed into the curved shape than the first direction.

According to yet another aspect of the present invention, a flexible thermoelectric module used in a curved shape, the module may comprise: a substrate provided in a plate shape deformable in a curved shape; a plurality of thermoelectric elements forming a two-dimensional array on the substrate, provided in a columnar shape, and including a N-type semiconductor and a P-type semiconductor, and a plurality of electrodes electrically connecting the plurality of thermoelectric elements along a length direction thereof, wherein the plurality of thermoelectric elements are electrically connected to the substrate and form a thermoelectric line extending in one direction, and wherein the thermoelectric line is arranged in a direction perpendicular to a curving direction for being deformed into the curved shape to minimize deformation of an electrode connecting thermoelectric elements belonging to the thermoelectric line when deformed into the curved shape.

According to yet another aspect of the present invention, a flexible thermoelectric module used in a curved shape may comprise a substrate provided in a plate shape deformable into a curved shape; a plurality of thermoelectric lines formed by electrically connecting a plurality of thermoelectric elements arranged in a line; and a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines, wherein a length direction of one of the first electrode and the second electrode which is smaller in number coincides with a curving direction for being deformed into the curved shape.

According to yet another aspect of the present invention, a flexible thermoelectric module used in a curved shape may include a substrate provided in a plate shape deformable into a curved shape; a plurality of thermoelectric lines formed by electrically connecting a plurality of thermoelectric elements arranged in a line on the substrate; and a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines, wherein the second electrode is arranged on the same main surface of the substrate in both edge regions of the substrate opposite to each other along the extending direction of the thermoelectric line.

According to yet another aspect of the present invention, a thermoelectric apparatus may include a casing exposed to an outside; and a flexible thermoelectric module installed in the casing and including a plurality of thermoelectric lines formed by electrically connecting a plurality of thermoelectric elements arranged in a line, a first electrode electrically connecting thermoelectric elements in the thermoelectric line and a second electrode electrically connecting the thermoelectric lines, wherein the first electrode is alternately arranged on a side exposed to an outside and a side opposite to the side exposed to the outside along the extending direction of the thermoelectric lines, and all of the second electrodes are arranged on the opposite side.

According to yet another aspect of the present invention, a flexible thermoelectric module used in a curved shape having a large-diameter portion and a small-diameter portion, the large-diameter portion and the small-diameter portion spaced apart from each other to face each other may include a substrate provided in a plate shape deformable into a curved shape; a plurality of thermoelectric lines formed by electrically connecting a plurality of thermoelectric elements arranged in a line; and a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines, wherein an edge having the second electrode in a smaller number between both edges of the substrate opposite to each other along the extending direction of the thermoelectric line is located at the small-diameter portion, and the other edge having the second electrode in a larger number is located at the large-diameter portion.

According to yet another aspect of the present invention, a flexible thermoelectric module used in a curved shape may include: a substrate provided in a plate shape deformable into a curved shape; a plurality of thermoelectric lines formed by electrically connecting thermoelectric elements arranged in a first direction, the thermoelectric lines being arranged along a second direction perpendicular to the first direction; and an electrode electrically connecting the thermoelectric elements, wherein the plurality of thermoelectric lines include first thermoelectric lines and second thermoelectric lines which are arranged in parallel with each other along the second direction, wherein thermoelectric elements arranged at one end in the first direction among the thermoelectric elements belonging to the first thermoelectric lines and the second thermoelectric lines are connected to a terminal, and thermoelectric elements arranged at the other end in the first direction among the thermoelectric elements belonging to the first thermoelectric lines and the second thermoelectric lines are connected to each other.

According to yet another aspect of the present invention, a flexible thermoelectric module used in a curved shape may include thermoelectric elements; electrodes connecting the thermoelectric elements, thermoelectric lines formed by thermoelectric elements linearly and sequentially connected by the electrodes; at least one thermoelectric group formed by the thermoelectric lines connected by the electrodes; and a substrate provided with the thermoelectric elements and the electrodes and provided in a plate shape deformable into a curved shape, the substrate having a plurality of regions connected to each other at a portion where the thermoelectric lines are connected and cut along an extending direction of the thermoelectric lines so as to be compartmentalized.

According to yet another aspect of the present invention, a flexible thermoelectric module used in a curved shape may include thermoelectric elements; electrodes connecting the thermoelectric elements; thermoelectric lines formed by thermoelectric elements linearly and sequentially connected by the electrodes; at least one thermoelectric group formed by the thermoelectric lines connected by the electrodes; and a substrate provided with the thermoelectric elements and the electrodes and provided in a plate shape deformable into a curved shape, the substrate having a base portion and a plurality of wing portions extending from the base portion in the extending direction of the thermoelectric line and cut away from each other.

According to yet another aspect of the present invention, a flexible thermoelectric module used in a curved shape may include a substrate provided in a plate shape deformable into a curved shape; and a plurality of thermoelectric lines formed by electrically connecting thermoelectric elements arranged in a line on the substrate and an electrode electrically connecting the thermoelectric elements, wherein the substrate includes a plurality of sub-substrates on which at least one of the thermoelectric lines is installed, and wherein the substrate is cut such that the sub-substrate is connected to an adjacent sub-substrate at one end thereof and is separated from the adjacent sub-substrate at the other end.

According to yet another aspect of the present invention, a thermoelectric apparatus may include a casing having a rim-shaped complex curved surface having a circular or elliptical cross section; and a flexible thermoelectric module installed on the casing, wherein the flexible thermoelectric module includes a substrate including a base portion installed along an inner-diameter surface close to a center of the rim and a wing portion extending from the base portion toward an outer-diameter surface of the rim and surrounding the circle or ellipse, a thermoelectric element installed on the substrate, and a first electrode connecting the thermoelectric element sequentially along an extending direction of the wing portion to form a thermoelectric line and a second electrode connecting the thermoelectric elements at the base portion along an extending direction of the base portion to form electrical connection between the thermoelectric lines.

The technical solutions of the present invention are not limited to the above-mentioned solutions, and the solutions which are not mentioned will be clearly understood by those skilled in the art from the present specification and the accompanying drawings.

### [Advantageous Effects]

According to an exemplary embodiment of the present invention, flexibility of a flexible thermoelectric module can be improved by arranging electrodes on a substrate in consideration of a direction in which the flexible thermoelectric module is curved.

According to another exemplary embodiment of the present invention, when a flexible thermoelectric module is curved, the curving angle of the electrodes is kept as small as possible so that breakage of the electrodes and a poor contact between the electrodes and the thermoelectric elements can be prevented.

According to still another exemplary embodiment of the present invention, as a partially cut substrate is used, a flexible thermoelectric module can be deformed into a complex curved shape that has a plurality of radii of curvature or has a curvature varying among positions.

The effects of the present invention are not limited to the above-mentioned effects, and the effects not mentioned will be clearly understood by those skilled in the art from the present specification and the accompanying drawings.

### [Description of Drawings]

FIGS. 1 and 2 are schematic views of a flexible thermoelectric module according to one exemplary embodiment of the present invention.
FIGS. 3 and 4 are views showing thermoelectric apparatuses equipped with the flexible thermoelectric module according to one exemplary embodiment of the present invention.
FIG. 5 is a view showing a first example of a layer structure of the flexible thermoelectric module according to one exemplary embodiment of the present invention.
FIG. 6 is a view showing the shape of a thermoelectric element used in the flexible thermoelectric module according to one exemplary embodiment of the present invention.
FIG. 7 is a view showing the shape of an electrode used in the flexible thermoelectric module according to one exemplary embodiment of the present invention.
FIG. 8 is a view showing a second example of the layer structure of the flexible thermoelectric module according to one exemplary embodiment of the present invention.
FIG. 9 is a view showing a third example of the layer structure of the flexible thermoelectric module according to one exemplary embodiment of the present invention.
FIG. 10 is a view showing a fourth example of the layer structure of the flexible thermoelectric module according to one exemplary embodiment of the present invention.
FIG. 11 is a diagram showing electrical characteristics according to a degree of curving of the flexible thermoelectric module according to one exemplary embodiment of the present invention.
FIG. 12 is a configuration diagram of a first example of the flexible thermoelectric module according to one exemplary embodiment of the present invention.
FIG. 13 is an assembled perspective view of one embodiment of a first example of the flexible thermoelectric module according to one exemplary embodiment of the present invention.
FIG. 14 is an exploded perspective view of one embodiment of the first example of the flexible thermoelectric module according to one exemplary embodiment of the present invention.
FIG. 15 is a view illustrating arrangement and electrical connection of thermoelectric elements in one embodiment of the first example of the flexible thermoelectric module according to one exemplary embodiment of the present invention.
FIG. 16 is a cross-sectional view of one embodiment of the first example of the flexible thermoelectric module according to one exemplary embodiment of the present invention, taken along line A1-A1'.
FIG. 17 is a cross-sectional view of one embodiment of the first example of the flexible thermoelectric module according to one exemplary embodiment of the present invention, taken along line B1-B1'.
FIG. 18 is a view showing one embodiment of the first example of the flexible thermoelectric module according to one exemplary embodiment of the present invention that is curved along direction A1-A1'.
FIG. 19 is a view showing one embodiment of the first example of the flexible thermoelectric module according to one exemplary embodiment of the present invention that is curved along direction B1-B1'.
FIG. 20 is a configuration diagram of a second example of the flexible thermoelectric module according to one exemplary embodiment of the present invention.
FIG. 21 is an assembled perspective view of one embodiment of the second example of the flexible thermoelectric module according to one exemplary embodiment of the present invention.
FIG. 22 is an exploded perspective view of one embodiment of the second example of the flexible thermoelectric module according to one exemplary embodiment of the present invention.
FIG. 23 is a view illustrating arrangement and electrical connection of thermoelectric elements in one embodiment of the second example of the flexible thermoelectric module according to one exemplary embodiment of the present invention.
FIG. 24 is a view showing one embodiment of the second example of the flexible thermoelectric module according to one exemplary embodiment of the present invention that is curved along direction A2-A2'.
FIG. 25 is a view showing one embodiment of the second example of the flexible thermoelectric module according to one exemplary embodiment of the present invention that is curved along direction B2-B2'.
FIG. 26 is an assembled perspective view of another embodiment of the second example of the flexible thermoelectric module according to one exemplary embodiment of the present invention.
FIG. 27 is an exploded perspective view of another embodiment of the second example of the flexible thermoelectric module according to one exemplary embodiment of the present invention.
FIG. 28 is a view illustrating arrangement and electrical connection of thermoelectric elements in another embodiment of the second example of the flexible thermoelectric module according to one exemplary embodiment of the present invention.
FIG. 29 is a view showing another embodiment of the second example of the flexible thermoelectric module according to one exemplary embodiment of the present invention that is curved along direction A3-A3'.
FIG. 30 is a view showing another embodiment of the second example of the flexible thermoelectric module according to one exemplary embodiment of the present invention that is curved along direction B3-B3'.
FIG. 31 is a view showing a thermoelectric apparatus equipped with one embodiment of a third example of the flexible thermoelectric module according to one exemplary embodiment of the present invention.
FIG. 32 is a view illustrating arrangement and electrical connection of thermoelectric elements in one embodiment of the third example of the flexible thermoelectric module according to one exemplary embodiment of the present invention.
FIG. 33 is a cross-sectional view of region C1 of one embodiment of the third example of the flexible thermoelectric module according to one exemplary embodiment of the present invention.
FIG. 34 is a cross-sectional view of region D1 of one embodiment of the third example of the flexible thermoelectric module according to one exemplary embodiment of the present invention.
FIG. 35 is a view showing a thermoelectric apparatus equipped with another embodiment of the third example of the flexible thermoelectric module according to one exemplary embodiment of the present invention.
FIG. 36 is a view illustrating arrangement and electrical connection of thermoelectric elements in another embodiment of the third example of the flexible thermoelectric module according to one exemplary embodiment of the present invention.
FIG. 37 is a cross-sectional view of region C2 of another embodiment of the third example of the flexible thermoelectric module according to one exemplary embodiment of the present invention.
FIG. 38 is a cross-sectional view of region D2 of another embodiment of the third example of the flexible thermoelectric module according to one exemplary embodiment of the present invention.
FIG. 39 is a view illustrating arrangement and electrical connection of thermoelectric elements in still another embodiment of the third example of the flexible thermoelectric module according to one exemplary embodiment of the present invention.
FIG. 40 is a cross-sectional view of region C3 of still another embodiment of the third example of the flexible thermoelectric module according to one exemplary embodiment of the present invention.
FIG. 41 is a cross-sectional view of region D3 of still another embodiment of the third example of the flexible thermoelectric module according to one exemplary embodiment of the present invention.
FIG. 42 is a view of a thermoelectric apparatus equipped with a fourth example of the flexible thermoelectric module according to one exemplary embodiment of the present invention.
FIG. 43 is a view illustrating arrangement and electrical connection of thermoelectric elements in the fourth example of the flexible thermoelectric module according to one exemplary embodiment of the present invention.
FIG. 44 is a view illustrating arrangement and electrical connection of thermoelectric elements in a fifth example of the flexible thermoelectric module according to one exemplary embodiment of the present invention.
FIG. 45 is a view showing a thermoelectric apparatus equipped with one embodiment of a sixth example of the flexible thermoelectric module according to one exemplary embodiment of the present invention.
FIG. 46 is a plan view of one embodiment of the sixth example of the flexible thermoelectric module according to one exemplary embodiment of the present invention.
FIG. 47 is a plan view of another embodiment of the sixth example of the flexible thermoelectric module according to one exemplary embodiment of the present invention.
FIG. 48 is a plan view of still another embodiment of the sixth example of the flexible thermoelectric module according to one exemplary embodiment of the present invention.
FIG. 49 shows a modification of one embodiment of the sixth example of the flexible thermoelectric module according to one exemplary embodiment of the present invention.
FIG. 50 is a block diagram of configuration of a thermoelectric apparatus according to one exemplary embodiment of the present invention.
FIG. 51 is a view showing a structure of the thermoelectric apparatus according to one exemplary embodiment of the present invention.
FIG. 52 is a view showing a structure of the thermoelectric apparatus to which a thermal buffer material is applied according to one exemplary embodiment of the present invention.

### [Best mode of the Invention]

According to an aspect of the present invention to achieve the above object, a flexible thermoelectric module used in a curved shape, the module may comprise: a substrate provided in a plate shape deformable in a curved shape; a plurality of thermoelectric elements including an N-type semiconductor and a P-type semiconductor arranged to form a two-dimensional array on the substrate; and a plurality of electrodes connecting the N-type semiconductor and the P-type semiconductor, wherein the plurality of thermoelectric elements are sequentially connected by the electrodes and forms a thermoelectric line including the thermoelectric elements forming a line shape, and wherein an extending direction of the thermoelectric line is closer to a direction perpendicular to a curving direction than the curving direction for being deformed into the curved shape.

### [Modes of the Invention]

The exemplary embodiments described herein are intended to clearly illustrate the spirit of the invention to those skilled in the art to which the invention pertains. It is to be understood that the invention is not limited to the embodiments described herein, but the scope of the invention should be construed as including modifications or variations that do not depart from the spirit of the invention.

Although the terms used in this specification are selected, as much as possible, from general terms that are widely used at present while taking into consideration the functions obtained in accordance with the present invention, these terms may be replaced by other terms based on intentions of those skilled in the art, customs, emergence of new technologies, or the like. Specific terms may be defined to have arbitrary meanings. In this case, the meanings of the terms will be disclosed separately. Accordingly, the terms used herein should be construed based on practical meanings thereof and the whole content of this specification rather than being simply construed based on names of the terms.

The accompanying drawings are intended to facilitate description of the present invention, and the shapes shown in the drawings may be exaggerated as needed to facilitate understanding of the present invention. Therefore, the present invention is not limited by the drawings.

In the following description, a detailed description of known configurations or functions related to the present invention will be omitted as needed when it may make the subject matter of the present invention rather unclear.

According to an aspect of the present invention, a flexible thermoelectric module used in a curved shape, the module may comprise: a substrate provided in a plate shape deformable into a curved shape; a plurality of thermoelectric elements including an N-type semiconductor and a P-type semiconductor arranged to form a two-dimensional array on the substrate; and a plurality of electrodes connecting the N-type semiconductor and the P-type semiconductor, wherein the plurality of thermoelectric elements are sequentially connected by the electrodes and forms a thermoelectric line including the thermoelectric elements forming a line shape, and wherein an extending direction of the thermoelectric line is closer to a direction perpendicular to a curving direction than the curving direction for being deformed into the curved shape.

Herein, the extending direction of the thermoelectric line may be perpendicular to the curving direction.

Herein, the thermoelectric line may be plural, and an arrangement direction among the plurality of thermoelectric lines may be coincident with the curving direction.

According to another aspect of the present invention, a flexible thermoelectric module used in a curved shape may comprise a substrate provided in a plate shape deformable into a curved shape; a plurality of thermoelectric elements including an N-type semiconductor and a P-type semiconductor arranged to form a two-dimensional array on the substrate; a first electrode connecting the N-type semiconductor and the P-type semiconductor along a first direction; and a second electrode connecting the N-type semiconductor and the P-type semiconductor along a second direction perpendicular to the first direction, wherein a curving direction for being deformed into the curved shape coincides with a direction along which one of the first electrode and the second electrode that is smaller in number connects the N-type semiconductor and the P-type semiconductor.

According to still another aspect of the present invention, a flexible thermoelectric module used in a curved shape, the module may comprise: a substrate provided in a plate shape deformable into a curved shape; a plurality of thermoelectric elements including an N-type semiconductor and a P-type semiconductor arranged to form a two-dimensional array on the substrate; a first electrode connecting the thermoelectric element sequentially along a first direction to form a thermoelectric line; and a second electrode connecting the thermoelectric element along a second direction perpendicular to the first direction to form an electrical connection between the thermoelectric line, wherein the second direction is closer to a curving direction for being deformed into the curved shape than the first direction.

Herein, the first direction may be perpendicular to the curving direction, and the second direction may be coincident with the curving direction.

According to yet another aspect of the present invention, a flexible thermoelectric module used in a curved shape, the module may comprise: a substrate provided in a plate shape deformable into a curved shape; a plurality of thermoelectric elements forming a two-dimensional array on the substrate, provided in a columnar shape, and including a N-type semiconductor and a P-type semiconductor, and a plurality of electrodes electrically connecting the plurality of thermoelectric elements along a length direction thereof, wherein the plurality of thermoelectric elements are electrically connected to the substrate and form a thermoelectric line extending in one direction, and wherein the thermoelectric line is arranged in a direction perpendicular to a curving direction for being deformed into the curved shape to minimize deformation of an electrode connecting thermoelectric elements belonging to the thermoelectric line when deformed into the curved shape.

Herein, the electrode may be arranged on one side of the substrate to face the plurality of thermoelectric elements, provided in a plate shape having a length dimension larger than a width dimension, and may electrically connect the plurality of thermoelectric elements by both ends along a length direction of the electrodes contacting with a N-type semiconductor and a P-type semiconductor which are adjacent respectively to each of the both ends.

Herein, a plurality of thermoelectric lines may be arranged along the curving direction on the substrate, thermoelectric lines electrically connected among the plurality of thermoelectric lines may form a thermoelectric group, and an electrode among the electrodes forming the electrical connection between thermoelectric lines constituting the thermoelectric group may be arranged so that a length direction thereof is coincident with the curving direction.

According to yet another aspect of the present invention, a flexible thermoelectric module used in a curved shape may comprise a substrate provided in a plate shape deformable into a curved shape, a plurality of thermoelectric lines formed by electrically connecting a plurality of thermoelectric elements arranged in a line, and a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines, wherein a length direction of one of the first electrode and the second electrode which is smaller in number coincides with a curving direction for being deformed into the curved shape.

Herein, a length direction of the second electrode may be coincident with the curving direction.

Herein, the second electrode may be arranged on the same main surface of the substrate in both edge regions of the substrate opposite to each other along the extending direction of the thermoelectric line.

According to yet another aspect of the present invention, a flexible thermoelectric module used in a curved shape may include a substrate provided in a plate shape deformable into a curved shape, a plurality of thermoelectric lines formed by electrically connecting a plurality of thermoelectric elements arranged in a line on the substrate, and a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines, wherein the second electrode is arranged on the same main surface of the substrate in both edge regions of the substrate opposite to each other along the extending direction of the thermoelectric line.

Herein, the main surface on a side on which the second electrode is arranged between the both main surfaces of the substrate may be a surface opposite to a surface exposed when the flexible thermoelectric module is used in the curved shape.

Herein, the main surface on a side on which the second electrode is arranged between the both main surfaces of the substrate may be a convex surface when the flexible thermoelectric module is used in the curved shape.

Herein, the substrate may include an inner substrate having thermoelectric element inserted therein, the main substrate having the electrode arrange on a main surface thereof, and an outer substrate arranged to face the inner substrate with respect to the electrode, wherein only one sheet of the outer substrate may be arranged on one side of both main surfaces of the inner substrate, and the second electrode may be arranged between the outer substrate and the inner substrate.

Herein, the number of thermoelectric elements included in the thermoelectric line may be 2n (where n is a natural number).

Herein, the second electrode may be arranged such that a length direction thereof coincides with a curving direction for being deformed into the curved shape.

According to yet another aspect of the present invention, a thermoelectric apparatus may include a casing exposed to an outside and a flexible thermoelectric module installed in the casing and including a plurality of thermoelectric lines formed by electrically connecting a plurality of thermoelectric elements arranged in a line, a first electrode electrically connecting thermoelectric elements in the thermoelectric line and a second electrode electrically connecting the thermoelectric lines, wherein the first electrode is alternately arranged on a side exposed to an outside and a side opposite to the side exposed to the outside along the extending direction of the thermoelectric lines, and all of the second electrodes are arranged on the opposite side.

Herein, the thermoelectric module may be a flexible thermoelectric module and may be curved along the length direction of the second electrode and installed on the casing in the curved shape.

According to yet another aspect of the present invention, a flexible thermoelectric module used in a curved shape having a large-diameter portion and a small-diameter portion, the large-diameter portion and the small-diameter portion spaced apart from each other to face each other may include a substrate provided in a plate shape deformable into a curved shape, a plurality of thermoelectric lines formed by electrically connecting a plurality of thermoelectric elements arranged in a line, and a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines, wherein an edge having the second electrode in a smaller number between both edges of the substrate opposite to each other along the extending direction of the thermoelectric line is located at the small-diameter portion, and the other edge having the second electrode in a larger number is located at the large-diameter portion.

According to yet another aspect of the present invention, a flexible thermoelectric module used in a curved shape may include: a substrate provided in a plate shape deformable into a curved shape; a plurality of thermoelectric lines formed by electrically connecting thermoelectric elements arranged in a first direction, the thermoelectric lines being arranged along a second direction perpendicular to the first direction; and an electrode electrically connecting the thermoelectric elements, wherein the plurality of thermoelectric lines include first thermoelectric lines and second thermoelectric lines which are arranged in parallel with each other along the second direction, wherein thermoelectric elements arranged at one end in the first direction among the thermoelectric elements belonging to the first thermoelectric lines and the second thermoelectric lines are connected to a terminal, and thermoelectric elements arranged at the other end in the first direction among the thermoelectric elements belonging to the first thermoelectric lines and the second thermoelectric lines are connected to each other.

According to yet another aspect of the present invention, a flexible thermoelectric module used in a curved shape may include thermoelectric elements, electrodes connecting the thermoelectric elements; thermoelectric lines formed by thermoelectric elements linearly and sequentially connected by the electrodes, at least one thermoelectric group formed by the thermoelectric lines connected by the electrodes, and a substrate provided with the thermoelectric elements and the electrodes and provided in a plate shape deformable into a curved shape, the substrate having a plurality of regions connected to each other at a portion where the thermoelectric lines are connected and cut along an extending direction of the thermoelectric lines so as to be compartmentalized.

Herein, each of the plurality of regions may be connected to an adjacent region at one edge of the substrate perpendicular to the extending direction of the thermoelectric lines.

Herein, each of the plurality of regions may be connected to two adjacent regions at one end and the other end in the extending direction of the thermoelectric lines.

According to yet another aspect of the present invention, a flexible thermoelectric module used in a curved shape may include thermoelectric elements, electrodes connecting the thermoelectric elements, thermoelectric lines formed by thermoelectric elements linearly and sequentially connected by the electrodes, at least one thermoelectric group formed by the thermoelectric lines connected by the electrodes, and a substrate provided with the thermoelectric elements and the electrodes and provided in a plate shape deformable into a curved shape, the substrate having a base portion and a plurality of wing portions extending from the base portion in the extending direction of the thermoelectric line and cut away from each other.

Herein, the base portion may be formed at one edge portion of the substrate.

Herein, the base portion may be formed at a central portion of the substrate, and the wing portions may be formed from the central portion on both sides along the extending direction of the thermoelectric lines.

Herein, when the flexible thermoelectric module is provided on a complex curved surface, the base portion may be provided at a portion having a constant curvature, and the wing portions may be provided at a portion having a curvature that changes along the extending direction thereof.

Herein, when the flexible thermoelectric module is provided on a complex curved surface, the base portion may be provided along a portion having the smallest radius of curvature.

Herein, when the flexible thermoelectric module is installed on a steering wheel, the base portion may be arranged along an inner-diameter surface of the steering wheel.

According to yet another aspect of the present invention, a flexible thermoelectric module used in a curved shape may include a substrate provided in a plate shape deformable into a curved shape and a plurality of thermoelectric lines formed by electrically connecting thermoelectric elements arranged in a line on the substrate and an electrode electrically connecting the thermoelectric elements, wherein the substrate includes a plurality of sub-substrates on which at least one of the thermoelectric lines is installed, and wherein the substrate is cut such that the sub-substrate is connected to an adjacent sub-substrate at one end thereof and is separated from the adjacent sub-substrate at the other end.

Herein, the substrate may have a region where the sub-substrates are connected to each other at one side along an extending direction of the thermoelectric lines.

Herein, a spacing between the sub-substrates may be constant from a portion where the sub-substrates are connected to a portion where the sub-substrates are separated.

Herein, the spacing between the sub-substrates may vary from a portion where the sub-substrates are connected to a portion where the sub-substrates are separated.

Herein, the spacing between the sub-substrates may increase as the distance from the portion where the sub-substrate are connected increases.

Herein, the spacing between the sub-substrates may decrease from the portion where the sub-substrates are connected.

Herein, the sub-substrate may be connected to one of two adjacent sub-substrates at one end thereof and to one of the two adjacent sub-substrates at the other end thereof.

Herein, the sub-substrate may be connected to two adjacent sub-substrates at one end thereof.

Herein, the sub-substrates may be deformed into a complex curved shape having two or more radii of curvature as the sub-substrates are curved individually.

Herein, the sub-substrates may be deformed into a complex curved shape having two or more radii of curvature as the sub-substrates are curved individually.

According to yet another aspect of the present invention, a thermoelectric apparatus may include a casing having a rim-shaped complex curved surface having a circular or elliptical cross section and a flexible thermoelectric module installed on the casing, wherein the flexible thermoelectric module includes a substrate including a base portion installed along an inner-diameter surface close to a center of the rim and a wing portion extending from the base portion toward an outer-diameter surface of the rim and surrounding the circle or ellipse, a thermoelectric element installed on the substrate, a first electrode connecting the thermoelectric element sequentially along an extending direction of the wing portion to form a thermoelectric line, and a second electrode connecting the thermoelectric elements at the base portion along an extending direction of the base portion to form electrical connection between the thermoelectric lines.

### 1. Definition and use of flexible thermoelectric module

Hereinafter, a flexible thermoelectric module 1000 according to one exemplary embodiment of the present invention will be described.

The flexible thermoelectric module 1000 according to the embodiment of the present invention refers to a thermoelectric module having flexibility.

Herein, the thermoelectric module may refer to a module configured to perform a thermoelectric operation, such as a power generation operation using a temperature difference or a heating/cooling operation using electric energy by utilizing a thermoelectric effect such as the Seeback effect or the Peltier effect.

In general, a conventional thermoelectric module is provided by electrically connecting thermoelectric elements consisting of N-P semiconductors on a flat substrate of a ceramic material. Accordingly, the conventional thermoelectric module is fundamentally fixed in a plate shape, and thus has limited applications.

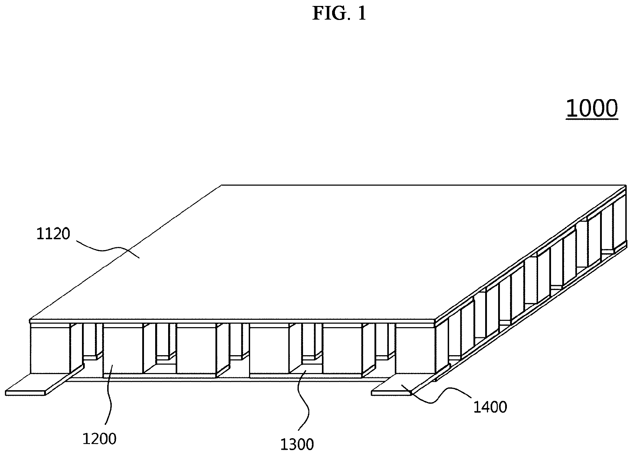

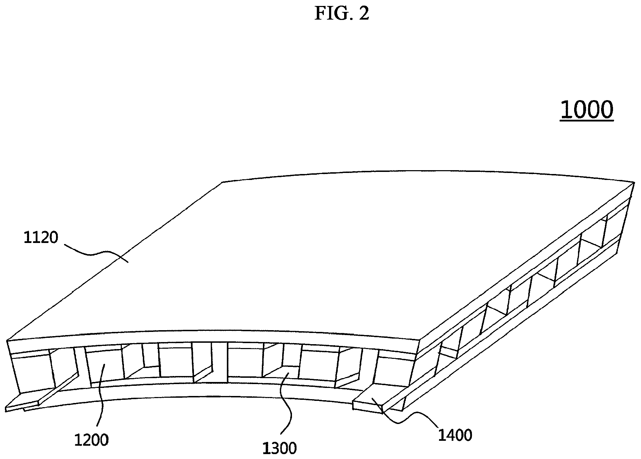

FIGS. 1 and 2 are schematic views of the flexible thermoelectric module 1000 according to one exemplary embodiment of the present invention.

Referring to FIGS. 1 and 2, in comparison with the conventional non-flexible thermoelectric module, the flexible thermoelectric module 1000 according to one exemplary embodiment of the present invention has flexibility and thus is deformable into various shapes, including a curved shape, although the flexible thermoelectric module is basically provided in a plate shape.

The flexible thermoelectric module 1000 deformable into a curved shape or the like may be utilized in various applications for which the conventional non-flexible thermoelectric module cannot be employed.

Regarding some examples of various applications for which the flexible thermoelectric module 1000 can be utilized, some thermoelectric apparatuses 100 on which the flexible thermoelectric module 1000 is mounted will be described. Here, the thermoelectric apparatuses 100 on which the flexible thermoelectric module 1000 is mounted may be apparatuses that perform any operation using the thermoelectric effect of the flexible thermoelectric module 1000.

For example, the thermoelectric apparatus 100 may be an apparatus that performs a power generation operation using the Seebeck effect. The thermoelectric apparatus 100 using the Seebeck effect may include a wearable device such as clothes for body-temperature power generation, a power generation apparatus installed on a pipeline of a factory or the like to generate power using waste heat, or a sensing device configured to sense a temperature using a voltage or current of electric energy produced by a temperature difference.

As another example, the thermoelectric apparatus 100 may be an apparatus that performs a heat generation/heat absorption operation or a heating/cooling operation using the Peltier effect. The thermoelectric apparatus 100 using the Peltier effect may include a cooling device configured to cool a refrigerant fluid in an air conditioner or a refrigerator, a baking apparatus configured to bake a wafer such as semiconductors using a capability of fine heating according to an input power, or a feedback device configured to output thermal feedback according to the Peltier effect to deliver a thermal sensation to a user.

Since the thermoelectric apparatus 100 may include various other types, the thermoelectric apparatus 100 is not limited to the above-described examples.

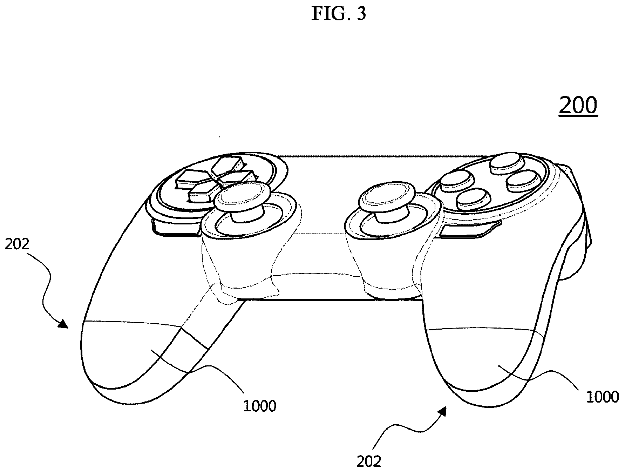

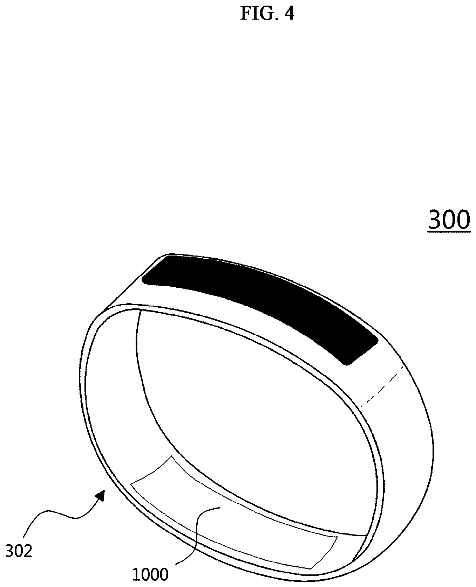

FIGS. 3 and 4 are views showing thermoelectric apparatuses 100 equipped with the flexible thermoelectric module 1000 according to one exemplary embodiment of the present invention.

Referring to FIG. 3, according to an example, the thermoelectric apparatus 100 may be provided in the form of a gaming controller 200. The flexible thermoelectric module 1000 may be mounted on the stick-shaped gaming controller 200 such that the flexible thermoelectric module 1000 surrounds a cylindrical grip portion 202. Specifically, the flexible thermoelectric module 1000 may be installed on or near the surface of the grip portion 202. Here, the flexible thermoelectric module 1000 mounted on the gaming controller 200 may output thermal feedback that causes a warm sensation, a cool sensation, or a painful heat sensation to a user during a process of a game.

Referring to FIG. 4, the thermoelectric apparatus 100 may be provided in the form of a smart watch 300 according to another example. The flexible thermoelectric module 1000 may be mounted on a band portion 302 of the smart watch 300 or the like such that the flexible thermoelectric module surrounds a wearable surface. Here, the flexible thermoelectric module 1000 mounted on the smart watch 300 may produce electric energy using a difference between a body temperature and an atmospheric temperature to supply operating power to the smart watch 300.

The conventional non-flexible thermoelectric elements have a very low usability except for some special applications because the outer shape thereof is fixed mainly in a flat plate shape as mentioned above. On the contrary, the flexible thermoelectric module 1000 according to the embodiment of the present invention has a very high usability as the flexible thermoelectric module is deformable into a suitable shape for various applications including the applications of FIGS. 3 and 4.

### 2. Layer structure of flexible thermoelectric module

Hereinafter, a layer structure of the flexible thermoelectric module 1000 according to one exemplary embodiment of the present invention will be described.

The flexible thermoelectric module 1000 according to one exemplary embodiment of the present invention may have flexibility due to layer structures which will be described later. However, it should be noted that the present invention is not limited by the layer structures which will described later since the layer structures described below are merely a few representative examples of the layer structures for obtaining flexibility of the flexible thermoelectric module 1000.

In the examples of the layer structures described below, an outer substrate 1120 and a support layer 1140 of the flexible thermoelectric module 1000 both serve as a substrate that supports thermoelectric elements 1200 and electrodes 1300. Therefore, both the outer substrate and the support layer will be represented by a "substrate 1100." Accordingly, in this specification, the substrate 1100 is an expression including the outer substrate 1120 and the support layer 1140. In addition, the support layer 1140 will be referred to as an "inner substrate 1140" in contrast to the outer substrate 1120.

### 2.1. First layer structure

Hereinafter, a first example of the layer structure of the flexible thermoelectric module 1000 according to one exemplary embodiment of the present invention will be described.

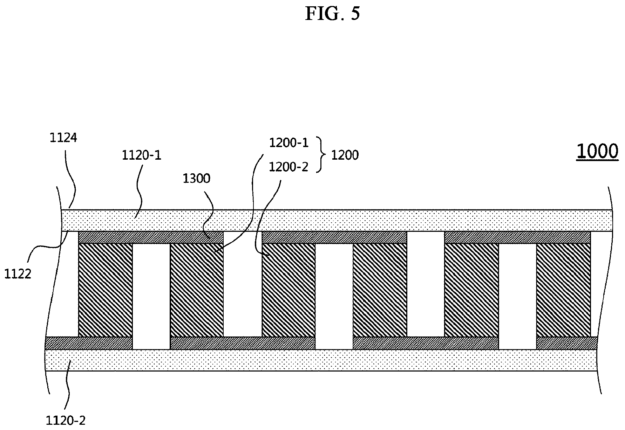

FIG. 5 is a view showing a first example of a layer structure of the flexible thermoelectric module 1000 according to one exemplary embodiment of the present invention.

Referring to FIGS. 1, 2 and 5, in the present example, the flexible thermoelectric module 1000 may include a pair of outer substrates 1120, thermoelectric elements 1200, an electrode 1300, and a terminal 1400.

The pair of outer substrates 1120 may include a first outer substrate 1120-1 and a second outer substrate 1120-2 which are spaced apart from each other so as to face each other. The first outer substrate 1120-1 and the second outer substrate 1120-2 support the thermoelectric elements 1200 and the electrode 1300 arranged therebetween. In addition, the outer substrates 1120 may function to protect the thermoelectric elements 1200 and the electrode 1300 which are inside the outer substrates from the outside. Here, one of both surfaces of one outer substrate 1120 that faces the other outer substrate 1120 is referred to as an inner surface 1122 of the outer substrate 1120, and the other surface opposite to the inner surface is referred to as an outer surface 1124 of the outer substrate 1120.

The outer substrates 1120 may be formed of a material that easily conducts heat and has flexibility. For example, the outer substrate 1120 may be a thin polyimide (PI) film. The PI film is not only excellent in flexibility but also may be advantageous for heat conduction because the PI film can be manufactured to have a small thickness although the thermal conductivity thereof is not high.

The thermoelectric elements 1200 may be elements that induce a thermoelectric effect such as the Seebeck effect or the Peltier effect. Basically, the thermoelectric elements 1200 may include a first thermoelectric element 1200-1 and a second thermoelectric element 1200-2 of different materials constituting a thermoelectric couple to cause a thermoelectric effect. The first thermoelectric element 1200-1 and the second thermoelectric element 1200-2 are electrically connected to form a thermoelectric couple. The thermoelectric couple may produce a temperature difference when electric energy is applied thereto and may produce electric energy when a temperature difference is applied. A typical example of the thermoelectric element 1200 is a pair of bismuth and antimony. In recent years, a pair of an N-type semiconductor and a P-type semiconductor is mainly used as the thermoelectric element 1200.

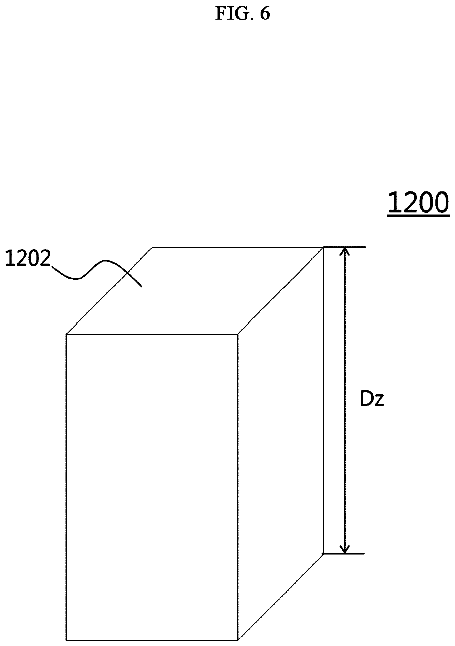

FIG. 6 is a view showing the shape of the thermoelectric element 1200 used in the flexible thermoelectric module 1000 according to one exemplary embodiment of the present invention.

Referring to FIGS. 5 and 6, the thermoelectric element 1200 may be provided mainly in a rectangular column shape or a circular column shape. Here, the thermoelectric element 1200 may have a height dimension Dz that is relatively small and thus may be closer to a plate shape than to a column as a whole. In the present specification, the expression "column shape" in relation to the shape of the thermoelectric element 1200 should be interpreted as a comprehensive expression including the plate shape.

The column-shaped thermoelectric element 1200 has both end surfaces 1202 in the height direction thereof. The end surfaces 1202 of the thermoelectric element 1200 may be planar.

The thermoelectric element 1200 of the above-described shape is arranged between the first outer substrate 1120-1 and the second outer substrate 1120-2 such that the height direction thereof coincides with the thickness direction of the flexible thermoelectric module 1000. The both end surfaces 1202 of the thermoelectric element 1200 may be directly or indirectly connected to the inner surfaces 1122 of the first outer substrate 1120-1 and the second outer substrate 1120-2 and thus be supported by the outer substrates 1120. Herein, "indirectly connected" may mean that two objects are not in direct contact with each other but are connected to each other via an intervening material arranged between the two objects. For example, as a typical form of indirect connection between the thermoelectric element 1200 and the outer substrates 1120, the end surfaces 1202 of the thermoelectric element 1200 may be connected to the inner surfaces 1122 of the outer substrates 1120 via an electrode 1300 interposed therebetween.

The thermoelectric elements 1200 may be arranged such that two thermoelectric elements 1200 adjacent to each other form a thermoelectric couple through the electrode 1300. For example, when the thermoelectric elements 1200 are arranged in a two-dimensional array, a first thermoelectric element 1200-1 and a second thermoelectric element 1200-2 may be alternately arranged along a specific direction. Accordingly, the first thermoelectric element 1200-1 and the second thermoelectric element 1200-2 are positioned adjacent to each other. In addition, the first thermoelectric elements 1200-1 are positioned to be staggered from each other. The second thermoelectric elements 1200-2 are also positioned to be staggered from each other.

The electrode 1300 electrically connects the thermoelectric elements 1200. The thermoelectric elements 1200 may exhibit a thermoelectric effect when at least the first thermoelectric element 1200-1 and the second thermoelectric element 1200-2 of different materials are electrically connected to form a thermoelectric couple. Accordingly, the electrode 1300 basically connects the first thermoelectric element 1200-1 and the second thermoelectric element 1200-2 which are adjacent to each other to form a thermoelectric couple.

In addition, the electrode 1300 may connect multiple thermoelectric elements 1200 in series. The thermoelectric elements 1200 connected in series by the electrode 1300 may form a thermoelectric group 1500 that performs the same thermoelectric operation at the same time.

In the present invention, the flexible thermoelectric module 1000 may include at least one thermoelectric group 1500. For example, all the thermoelectric elements 1200 of the flexible thermoelectric module 1000 may be connected in series, and thus the thermoelectric module 1000 may consist of one thermoelectric group 1500. Alternatively, a plurality of thermoelectric groups 1500 may be formed in the flexible thermoelectric module 1000. When the flexible thermoelectric module 1000 has a plurality of thermoelectric groups 1500, the operation of each thermoelectric group 1500 may be individually controllable, and therefore operation control may be performed for each region of the thermoelectric module 1000.

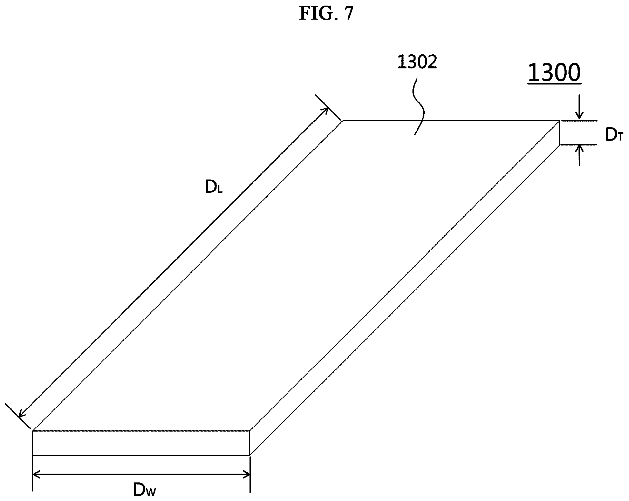

FIG. 7 is a view showing the shape of the electrode 1300 used in the flexible thermoelectric module 1000 according to one exemplary embodiment of the present invention.

Referring to FIGS. 5 and 7, the electrode 1300 may be provided mainly in a plate shape. Here, the plate-shaped electrode 1300 has a thick dimension D_{T}, a length dimension D_{L}, and a width dimension Dw. The plate-shaped electrode 1300 also has two main surfaces 1302 defined by a length direction and a width direction.

The electrode 1300 may be fixed to the outer substrate 1120 through one of the two major surfaces 1302. Here, the electrode 1300 may be fixed to the outer substrate 1120 by a screening technique, a bonding technique using an adhesive (for example, silicone, acrylic, urethane or the like) or various other attachment techniques. Hereinafter, one of the two main surfaces 1302 of the electrode 1300 that faces the inner surface 1122 of the outer substrate 1120 is referred to as an outer surface of the electrode 1300 and the opposite surface is referred to as an inner surface of the electrode 1300.

The electrode 1300 electrically connects the first thermoelectric element 1200-1 and the second thermoelectric element 1200-2 through the inner surface thereof.

The electrode 1300 may be arranged such that the length direction thereof coincides with the arrangement direction of the first thermoelectric elements 1200-1 and the second thermoelectric elements 1200-2 which form a thermoelectric couple and may connect the first thermoelectric elements 1200-1 and the second thermoelectric elements 1200-2 along the length direction. Structurally, one end region of the inner surface of the electrode 1300 in the length direction may be in direct or indirect contact with an end surface of the first thermoelectric element 1200-1 and the other end region of the inner surface of the electrode 1300 in the length direction may be in direct or indirect contact with an end surface of the thermoelectric element 1200-2. Accordingly, the electrode 1300 may electrically connect the first thermoelectric element 1200-1 and the second thermoelectric element 1200-2 through the inner surface thereof.

Here, the end surface 1202 of the thermoelectric element 1200 may be combined to the inner surface of the main surfaces 1302 of the electrode 1300 by soldering, welding, or the like. Accordingly, a material for combining the electrode 1300 and the thermoelectric element 1200 may be interposed between the end surface 1202 of the thermoelectric element 1200 and the end region of the electrode 1300.

The electrode 1300 may be mainly made of a metal such as copper or silver, but the present invention is not limited thereto.

The terminal 1400 is provided to connect the flexible thermoelectric module 1000 to the outside. When the flexible thermoelectric module 1000 is used as a heat outputting module, the terminal 1400 may supply power to allow the flexible thermoelectric module 1000 to perform the heating/cooling operation using the Peltier effect. When the flexible thermoelectric module 1000 is used as a thermoelectric generating module, the terminal 1400 may transmit, to the outside, the electric power produced by the flexible thermoelectric module 1000 using the Seebeck effect.

The terminal 1400 may be provided in pairs to each thermoelectric group 1500 and connected to the thermoelectric elements 1200 present at both ends of an electric circuit among the thermoelectric elements 1200 connected in series in the thermoelectric group 1500.

### 2.2. Second layer structure

Hereinafter, a second example of the layer structure of the flexible thermoelectric module 1000 according to one exemplary embodiment of the present invention will be described.

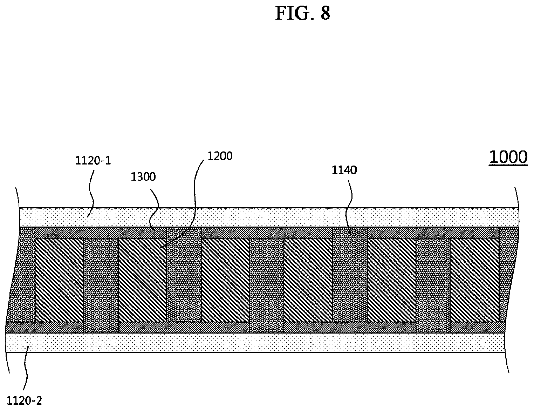

FIG. 8 is a view showing the second example of the layer structure of the flexible thermoelectric module according to one exemplary embodiment of the present invention.

Referring to FIGS. 1 and 8, in the present example, the flexible thermoelectric module 1000 may include a pair of outer substrates 1120, a support layer 1140, thermoelectric elements 1200, an electrode 1300, and a terminal 1400.

The present example is different from the first example of the layer structure of the flexible thermoelectric module 1000 according to one exemplary embodiment of the present invention in that the support layer 1140 is further provided.

The support layer 1140 is located between the first outer substrate 1120-1 and the second outer substrate 1120-2. The support layer 1140 may support the thermoelectric elements 1200 and the electrode 1300. Accordingly, the thermoelectric elements 1200 and the electrode 1300 may be supported by the support layer 1140 in addition to the outer substrates 1120.

Structurally, the support layer 1140 may be provided to fill an empty space between the outer substrates 1120. The outer substrates 1120 support the electrode 1300 through the outer surface of the electrode 1300. On the other hand, the support layer 1140 may support the electrode 1300 through the inner surface of the electrode 1300 and the side surface of the electrode 1300, thereby supporting the electrode 1300 more stably. Of course, the support layer 1140 may not necessarily be in contact with the entire side surface of the electrode 1300. The outer substrates 1120 are connected to the end surfaces of the thermoelectric element 1200 through the electrode 1300 to support the thermoelectric element 1200. On the other hand, the support layer 1140 may be in direct contact with the side surface of the thermoelectric element 1200, thereby supporting the thermoelectric element 1200 more stably.

Therefore, the support layer 1140 as well as the outer substrates 1120 may add a supporting force to the thermoelectric element 1200 and the electrode 1300, thereby minimizing poor contact, clearance, and separation of the flexible thermoelectric element 1200 or the electrode 1300 when the thermoelectric element 1200 is deformed by curving or the like.

The support layer 1140 may be formed of a flexible material so that the flexible thermoelectric module 1000 can maintain flexibility. For example, the support layer 1140 may be a foam layer having inner pores like a sponge. Here, the foam layer may be formed by filling the space between the outer substrate 1120 and the outer substrate 1120 with a foaming agent. Here, filling of the foaming agent may be performed on the flexible thermoelectric module 1000, which is in such a state, as the state of the first example of the layer structure of the flexible thermoelectric module 1000 according to one exemplary embodiment of the present invention. As the foaming agent, an organic foaming agent, an inorganic foaming agent, a physical foaming agent, polyurethane, and a silicon foam may be used.

### 3.3. Third layer structure

Hereinafter, a third example of the layer structure of the flexible thermoelectric module 1000 according to one exemplary embodiment of the present invention will be described.

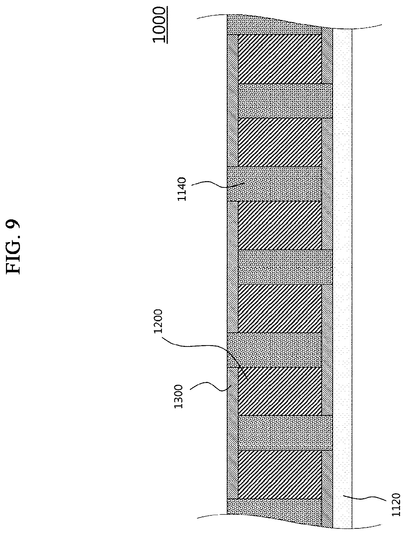

FIG. 9 is a view showing a third example of the layer structure of the flexible thermoelectric module 1000 according to one exemplary embodiment of the present invention.

Referring to FIG. 9, in the present example, the flexible thermoelectric module 1000 may include a single outer substrate 1120, a support layer 1140, a thermoelectric element 1200, an electrode 1300, and a terminal 1400.

The present example is different from the second example of the layer structure of the flexible thermoelectric module 1000 according to one exemplary embodiment of the present invention in that only one outer substrate 1120 is provided.

When the support layer 1140 is included in the flexible thermoelectric module 1000, the thermoelectric element 1200 and the electrode 1300 may be supported by the support layer 1140, and therefore the outer substrate 1120 may not necessarily be required.

The flexible thermoelectric module 1000 according to the present example may be manufactured by removing any one of the outer substrates 1120 from the flexible thermoelectric module 1000 in such a state as the state of the second example of the layer structure of the flexible thermoelectric module 1000 according to one exemplary embodiment of the present invention. Here, the outer substrate 1120 may be removed through physical, chemical, or mechanical separation.

The flexible thermoelectric module 1000 having the outer substrate 1120 only on one surface thereof has enhanced flexibility compared to the flexible thermoelectric module 1000 having the outer substrates 1120 on both surfaces thereof. This is because the outer substrate 1120 is resistant to curving or the like to a certain degree even when the outer substrate 1120 is formed of a flexible material such as a PI film.

In the case of the flexible thermoelectric module 1000 having the outer substrate 1120 only on one surface thereof, durability of the electrode 1300 arranged on the other surface of the flexible thermoelectric module 1000 on which the outer substrate 1120 is not provided may be degraded to a certain degree due to the absence of the outer substrate 1120. When the flexible thermoelectric module 1000 is used such that the surface thereof having the outer substrate 1120 is used as a portion where the flexible thermoelectric module 1000 is exposed to the outside, the above-described disadvantage may be minimized.

On the other hand, in the case of the flexible thermoelectric module 1000 having the outer substrate 1120 only on one surface thereof, the flexibility of the surface thereof without the outer substrate 1120 may be higher than the opposite surface. When the flexible thermoelectric module 1000 is used in a curved shape, forming the surface without the outer substrate 1120 in a convex shape may fully utilize the above-described advantage.

### 2.4. Fourth layer structure

Hereinafter, a fourth example of the layer structure of the flexible thermoelectric module 1000 according to one exemplary embodiment of the present invention will be described.

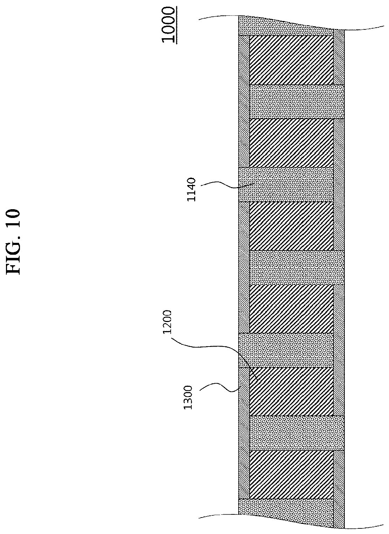

FIG. 10 is a view showing the fourth example of the layer structure of the flexible thermoelectric module 1000 according to one exemplary embodiment of the present invention.

Referring to FIG. 10, in the present example, the flexible thermoelectric module 1000 may include a support layer 1140, thermoelectric elements 1200, an electrode 1300, and a terminal 1400.

The present example is different from the second example of the layer structure of the flexible thermoelectric module 1000 according to one exemplary embodiment of the present invention in that no outer substrate 1120 is provided.

When the support layer 1140 is included in the flexible thermoelectric module 1000 as described above, the thermoelectric element 1200 and the electrode 1300 may be supported by the support layer 1140, and therefore the outer substrate 1120 may not necessarily be required.

The flexible thermoelectric module 1000 according to the present example may be manufactured by removing all the outer substrates 1120 from the flexible thermoelectric module 1000 in such a state as the state of the second example of the layer structure of the flexible thermoelectric module 1000 according to one exemplary embodiment of the present invention. Here, the outer substrates 1120 may be removed through physical, chemical, or mechanical separation.

The flexible thermoelectric module 1000 having only the support layer 1140 without the outer substrates 1120 has enhanced flexibility compared to the flexible thermoelectric module 1000 having the outer substrates 1120 on both surfaces thereof or having the outer substrate 1120 on only one surface thereof.

### 3. Flexible thermoelectric module having arrangement of thermoelectric elements and electrodes in consideration of a curving direction

Hereinafter, the flexible thermoelectric module 1000 having the thermoelectric elements 1200 and the electrodes 1300 arranged in consideration of the curving direction of the flexible thermoelectric module 1000 will be described.

As described above with reference to FIG. 7, the flexible thermoelectric module 1000 may generally employ a plate-shaped electrode 1300 having a length dimension larger than a width dimension.

The electrode 1300 is flexible to a certain degree, but the flexibility thereof may be less flexible than the outer substrate 1120 provided as a PI film or the inner substrate 1140, that is, the support layer 1140, provided as a foam layer. Accordingly, the arrangement direction of the electrode 1300 may greatly affect the flexibility of the entire flexible thermoelectric module 1000.

Specifically, when the flexible thermoelectric element 1200 is curved to the same degree, the electrode 1300 may be more resistant to deformation by curving along the length direction of the electrode 1300 than to deformation by curving along the width direction of the electrode 1300. In other words, in curving the flexible thermoelectric element 1200, curving along the width direction of the electrode 1300 may be more advantageous than curving along the length direction of the electrode 1300.

In addition, when the flexible thermoelectric element 1200 is curved, stress may be concentrated on the combined portions of the electrode 1300 and the thermoelectric element 1200, or defects may be produced on the combined portions. Curving the flexible thermoelectric element 1200 along the width direction of the electrode 1300 may be more suitable to solve problems occurring on the combined portions of the electrode 1300 and the flexible thermoelectric element 1200 than curving the flexible thermoelectric element 1200 along the length direction of the electrode 1300.

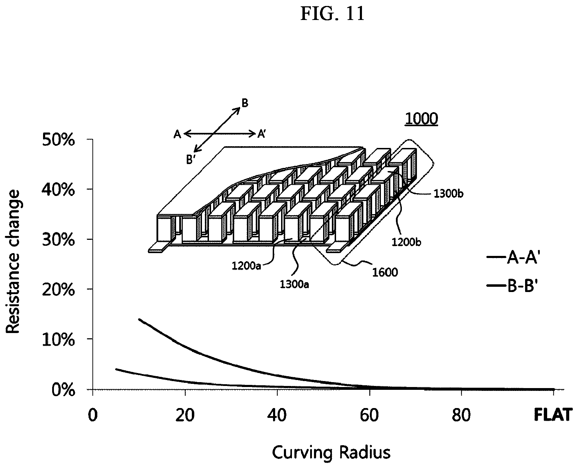

FIG. 11 is a diagram showing electrical characteristics according to a degree of curving of the flexible thermoelectric module 1000 according to one exemplary embodiment of the present invention.

FIG. 11 depicts resistance values of the flexible thermoelectric module 1000 measured while the flexible thermoelectric module 1000 is curved along directions A-A' and B-B'.

For the measurement, the flexible thermoelectric module 1000 having one thermoelectric group 1500 formed by connecting all the thermoelectric elements 1200 in series in a zigzag pattern is used.

Referring to FIG. 11, in the flexible thermoelectric module 1000 used for the measurement, the thermoelectric elements 1200 constitute a plurality of lines connected in series in the form of a one-dimensional array (hereinafter, referred to as "thermoelectric lines 1600"), and the thermoelectric lines 1600 are connected to each other in series. Accordingly, the plurality of thermoelectric elements 1200 may constitute one thermoelectric group 1500 composed of the plurality of thermoelectric lines 1600.

The series connection of the thermoelectric lines 1600 may be accomplished by connecting adjacent thermoelectric lines 1600 with the electrode 1300 at the ends of the adjacent thermoelectric lines 1600. Specifically, the thermoelectric line 1600 may be connected to an adjacent thermoelectric line 1600 through a thermoelectric element 1200 positioned at the end of the thermoelectric line 1600 among the thermoelectric elements 1200 belonging to the thermoelectric line 1600.

Hereinafter, the thermoelectric element 1200 that electrically connects the adjacent thermoelectric lines 1600 is referred to as a "connector thermoelectric element 1200a." In addition, the electrode 1300 that electrically connects the connecting thermoelectric elements 1200a belonging to each of two thermoelectric lines 1600 is referred to as a "connector electrode 1300a." In contrast, the other thermoelectric elements 1200 except for the connector thermoelectric element 1200a among the thermoelectric elements 1200 belonging to one thermoelectric line 1600 are referred to as "general thermoelectric elements 1200b," and the electrode 1300 that electrically connects the general thermoelectric elements 1200b is referred to as a "general electrode 1300b." It should be noted that the terms such as the connector thermoelectric element 1200a, the connector electrode 1300a, the general thermoelectric element 1200b, and the connecting electrode 1300b are arbitrarily defined for convenience of description to distinguish between positions in an arrangement or arrangement directions, not to distinguish between material qualities, materials, shapes or the like of the thermoelectric elements 1200 or the electrodes 1300.

In the flexible thermoelectric module 1000 used for the measurement, the thermoelectric lines 1600 extend along direction B-B'. Accordingly, the general electrode 1300b is arranged such that a length direction thereof coincides with direction B-B', and the connector electrode 1300a is arranged such that a length direction thereof coincides with direction A-A'. Accordingly, in the flexible thermoelectric module 1000 used for measurement, the majority of the electrodes 1300 are arranged with the length direction thereof aligned with direction B-B', and only the minority of the electrodes 1300 are arranged with the length direction thereof aligned with direction A-A'. The resistance was measured with respect to the terminals 1400 at both ends.

Referring to FIG. 11, it can be seen that the change in resistance of the flexible thermoelectric module 1000 in the case of curving in direction B-B' is significantly larger than that in the case of curving in direction A-A'. This suggests that the electrode 1300 of which a length direction coincides with the curving direction is a cause of degradation of performance of the flexible thermoelectric module 1000.

Accordingly, when the flexible thermoelectric element 1200 is used in a simple curved shape such as a cylindrical shape as shown in FIGS. 3 and 4, the performance of the flexible thermoelectric element 1200 may be improved by minimizing the electrodes 1300 of which length direction coincides with the curving direction.

Hereinafter, some representative examples of the flexible thermoelectric module 1000 having the thermoelectric elements 1200 and the electrodes 1300 arranged in consideration of the curving direction will be described.

It is to be noted that the following examples are merely intended to facilitate understanding of the present invention, and the present invention is not limited thereto.

In the following examples, the flexible thermoelectric module 1000 having the layer structure of FIG. 5 will be described. However, this is merely for convenience of explanation, and the flexible thermoelectric module 1000 in the following examples may have the layer structure of FIGS. 8 to 10 and other similar layer structures in addition to the layer structure of FIG. 5. That is, in the following examples, the layer structure of the flexible thermoelectric module 1000 can be combined, in various ways, with the arrangement of the thermoelectric elements 1200 and the electrodes 1300 that is made in consideration of the curving direction. Therefore, the present invention is not limited to the layer structure of FIG. 9.

Although the flexible thermoelectric module 1000 having the thermoelectric elements 1200 and the electrodes 1300 arranged in consideration of the curving direction will be described mainly in relation to FIG. 5, the flexible thermoelectric module 1000 is not limited to the layer structure of FIG. 5. In order to clearly show that the flexible thermoelectric module 1000 can be applied to various layer structures, including the layer structure of FIGS. 8 to 10, the expressions "outer substrate 1120" and "inner substrate 1140" or "support layer 1140" will be avoided if possible and the term "substrate 1100" covering all the aforementioned substrates will be used.

### 3.1. Flexible thermoelectric module having one thermoelectric group

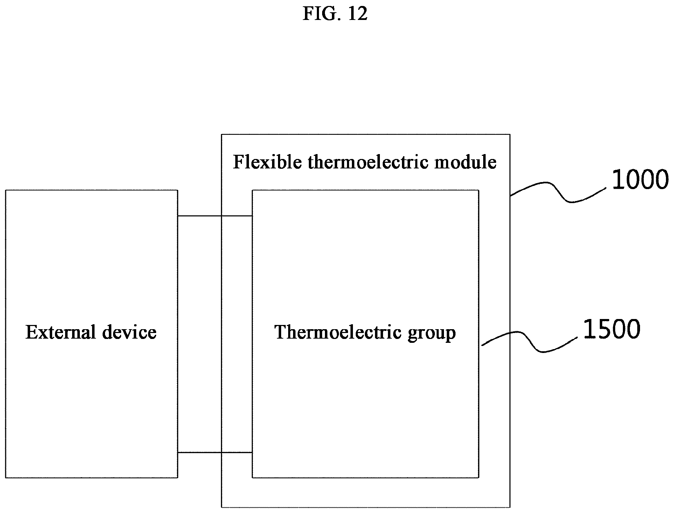

FIG. 12 is a configuration diagram of a first example of the flexible thermoelectric module 1000 according to one exemplary embodiment of the present invention.

In the present example, the flexible thermoelectric module 1000 has only one thermoelectric group 1500.

Referring to FIG. 12, the flexible thermoelectric module 1000 has a single thermoelectric group 1500, and the thermoelectric elements 1200 arranged at the beginning and the end of the electric circuit, among the serially connected thermoelectric elements 1200 constituting the thermoelectric group 1500, may be electrically connected to external devices such as a power source or a battery through the terminal 1400.

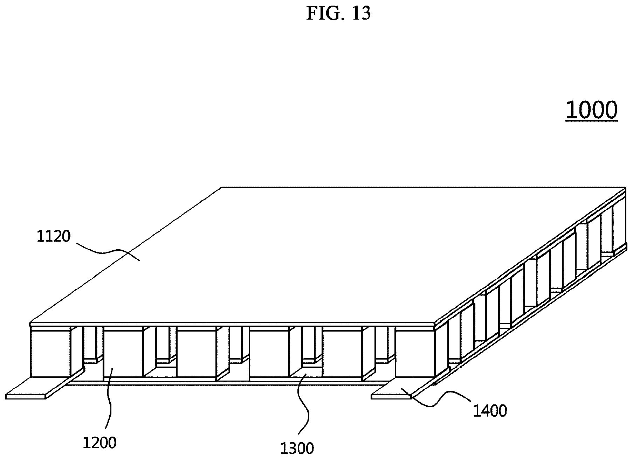

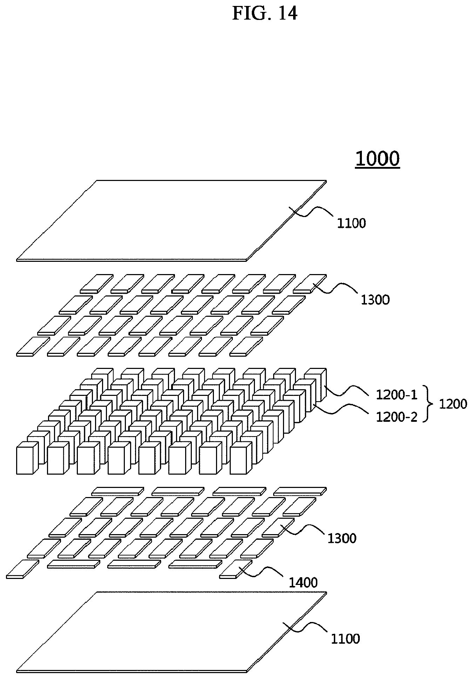

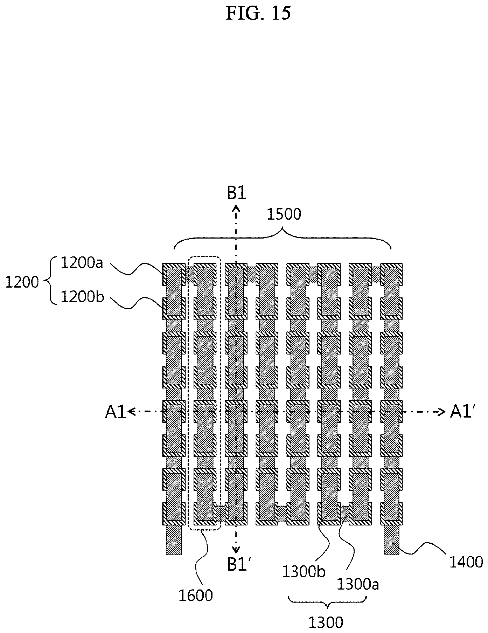

FIG. 13 is an assembled perspective view of one embodiment of a first example of the flexible thermoelectric module 1000 according to one exemplary embodiment of the present invention, and FIG. 14 is an exploded perspective view of one embodiment of the first example of the flexible thermoelectric module 1000 according to one exemplary embodiment of the present invention. FIG. 15 is a view illustrating arrangement and electrical connection of thermoelectric elements 1200 in one embodiment of the first example of the flexible thermoelectric module 1000 according to one exemplary embodiment of the present invention.

Referring to FIGS. 13 to 15, in this embodiment, the flexible thermoelectric module 1000 may have a plurality of thermoelectric elements 1200 arranged in a two-dimensional array. In the two-dimensional array, the thermoelectric elements 1200 may be arranged in a manner in which the first thermoelectric element 1200-1, for example, an N-type semiconductor, and the second thermoelectric element 1200-2, for example, a P-type semiconductor, are alternately arranged.

Here, the thermoelectric lines 1600 may be formed along direction B1-B1'. As described above, the thermoelectric line 1600 is formed by electrically connecting, in series, the thermoelectric elements 1200 that are spatially arranged in a line.

The thermoelectric lines 1600 are connected at the ends thereof to adjacent thermoelectric lines 1600 such that all the thermoelectric lines 1600 are connected in series.

Specifically, the thermoelectric lines 1600 except for the two thermoelectric lines 1600 located at the outermost positions in the two-dimensional array along direction A1-A1' may be connected to one of two thermoelectric lines 1600 adjacent thereto at one end and connected to the other one of the two thermoelectric lines 1600 at the other end located on the opposite side to the one end in the arrangement direction of the thermoelectric lines 1600.

The two thermoelectric lines 1600 located at the outermost positions in the two-dimensional array along direction A1-A1' among the thermoelectric lines 1600 may be connected to the terminal 1400 at one end and connected to the thermoelectric elements 1600 adjacent thereto at the other end.

Here, the thermoelectric line 1600 may be electrically connected to an adjacent thermoelectric line 1600 by connecting the connector thermoelectric element 1200a located at the end of the thermoelectric line 1600 to the connector thermoelectric element 1200a located at the end of the adjacent thermoelectric line 1600 via the connector electrode 1300a.

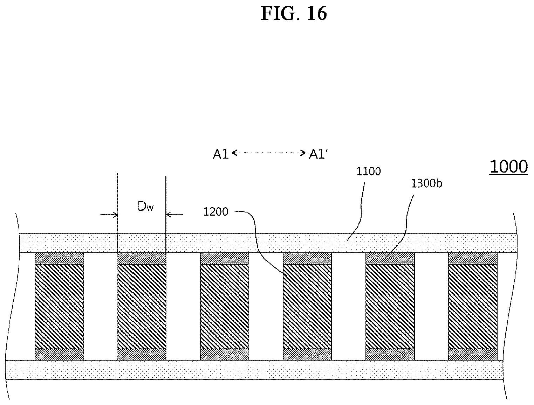

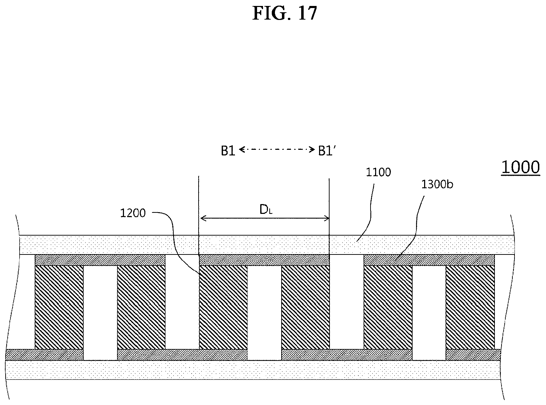

FIG. 16 is a cross-sectional view of one embodiment of the first example of the flexible thermoelectric module 1000 according to one exemplary embodiment of the present invention, taken along line A1-A1', and FIG. 17 is a cross-sectional view of one embodiment of the first example of the flexible thermoelectric module 1000 according to one exemplary embodiment of the present invention, taken along line B1-B1'.

Referring to FIG. 16, since the thermoelectric line 1600 extends in direction B1-B1', the general electrodes 1300b connecting the thermoelectric elements 1200 in the thermoelectric line 1600 are arranged such that the width direction thereof coincides with direction A1-A1'. Similarly, referring to FIG. 17, since the thermoelectric lines 1600 extend in direction B1-B1', the general electrodes 1300b connecting the thermoelectric elements 1200 in the thermoelectric lines 1600 are arranged such that the length direction thereof coincides with direction B1-B1'.

The length dimension of the electrode 1300 is larger than the width dimension thereof. Accordingly, when it is assumed that the electrode 1300 is curved to a constant curvature, the electrode 1300 may be curved more in the length direction thereof than in the width direction thereof. Thus, the electrode 1300 is less resistant to curving along the width direction thereof than to curving along the length direction thereof. Therefore, it may be advantageous to curve the flexible thermoelectric module 1000 in a direction as close to the width direction of the electrode 1300 as possible. In general, among the electrodes 1300 included in the flexible thermoelectric module 1000, the number of the general electrodes 1300b is larger than that of the connector electrodes 1300a. Therefore, in the case where the flexible thermoelectric module 1000 is used in a curved shape curved in a specific direction, the flexible thermoelectric module 1000 may secure high flexibility and durability against curving when the width direction of the general electrodes 1300b coincides with the specific direction.

The width direction of the general electrode 1300b coincides with the length direction of the connector electrode 1300a and the arrangement direction across the thermoelectric lines 1600. In addition, the width direction of the general electrode 1300b may be perpendicular to the length direction of the general electrode 1300b, the width direction of the connector electrode 1300a, the arrangement direction of the thermoelectric elements 1200 in the thermoelectric line 1600, and the arrangement direction of the thermoelectric line 1600. Accordingly, in order to secure high flexibility and durability against curving when the flexible thermoelectric module 1000 is used in a curved shape curved in a specific direction, the arrangement and arrangement relationship of the thermoelectric elements 1200 and the electrodes 1300 may be determined so that the length direction of the general electrodes 1300b, the width direction of the connector electrodes 1300a, the arrangement direction of the thermoelectric elements 1200 in the thermoelectric line 1600 and the arrangement direction of the thermoelectric lines 1600 coincide with the specific direction, and the width direction of the general electrodes 1300b, the length direction of the connector electrodes 1300a, and the arrangement direction across the thermoelectric lines 1600 are perpendicular to the specific direction.

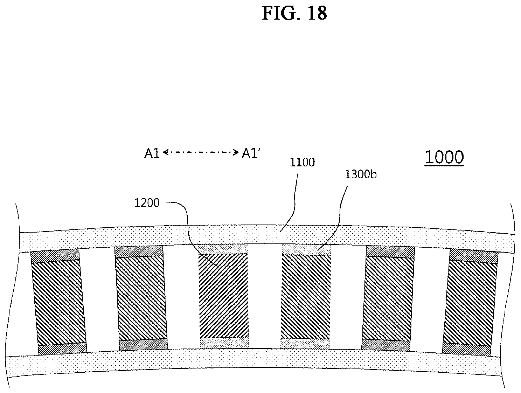

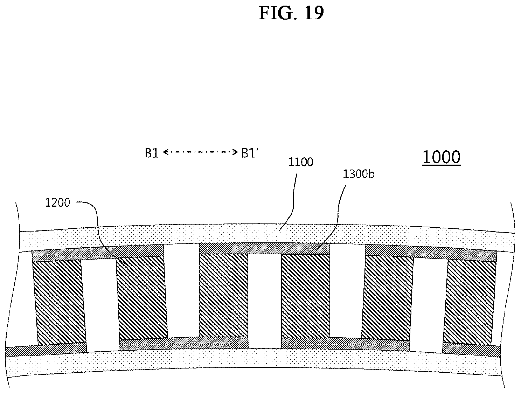

FIG. 18 is a view showing one embodiment of the first example of the flexible thermoelectric module 1000 according to one exemplary embodiment of the present invention that is curved along direction A1-A1', and FIG. 19 is a view showing one embodiment of the first example of the flexible thermoelectric module 1000 according to one exemplary embodiment of the present invention that is curved along the direction B1-B1'.

Referring to FIG. 18, when the flexible thermoelectric module 1000 is curved in direction A1-A1', the general electrodes 1300b may be curved along the width direction thereof. Referring to FIG. 19, when the flexible thermoelectric module 1000 is curved in direction B1-B1', the general electrodes 1300b may be curved along the length direction thereof.

The connector electrodes 1300a, which are relatively small in number, have only a minor influence on curving of the flexible thermoelectric module 1000 compared to the influence of the general electrodes 1300b. Therefore, mainly considering the influence of the general electrodes 1300b among the electrodes 1300 on curving of the flexible thermoelectric module 1000, it may be advantageous for the width direction of the general thermoelectric elements 1200b to coincide with the curving direction. That is, in the case where the flexible thermoelectric elements 1200 are to be curved in a specific direction and used, it may be more advantageous to make the arrangement direction of the thermoelectric lines 1600 perpendicular to the curving direction than to make the arrangement direction of the thermoelectric lines 1600 coincide with the curving direction.

### 3.2. Flexible thermoelectric module having a plurality of thermoelectric groups

In the present example, the flexible thermoelectric module 1000 may include a plurality of thermoelectric groups 1500.

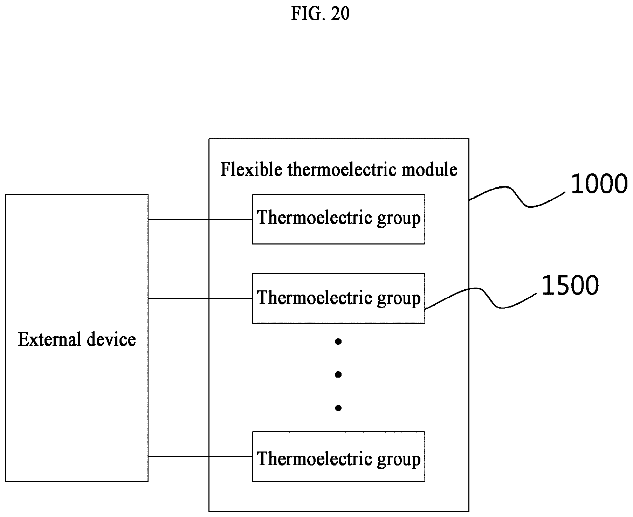

FIG. 20 is a configuration diagram of a second example of the flexible thermoelectric module 1000 according to one exemplary embodiment of the present invention.

Referring to FIG. 20, the flexible thermoelectric module 1000 may have a plurality of thermoelectric groups 1500, and the thermoelectric elements 1200 arranged at the beginning and the end of the electric circuit, among the serially connected thermoelectric elements 1200 constituting the thermoelectric groups 1500, may be electrically connected to external devices such as a power source or a battery through the terminal 1400.

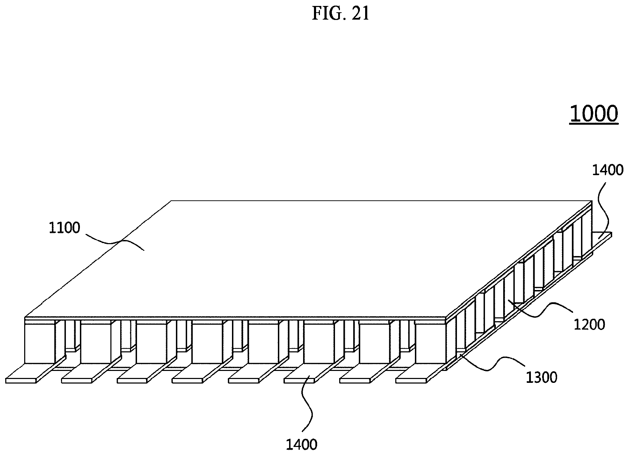

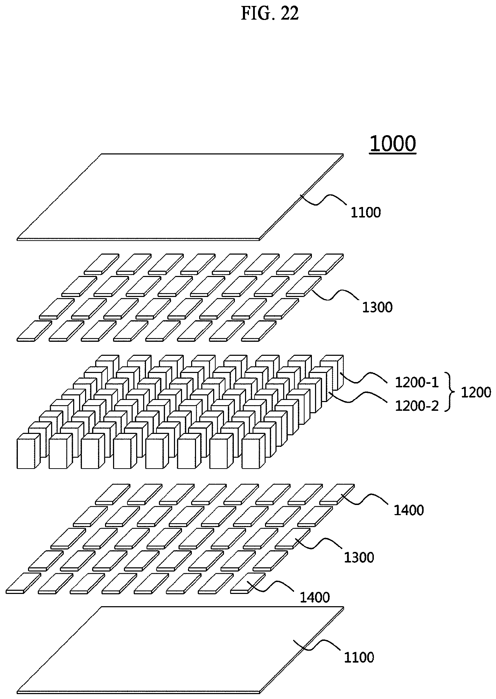

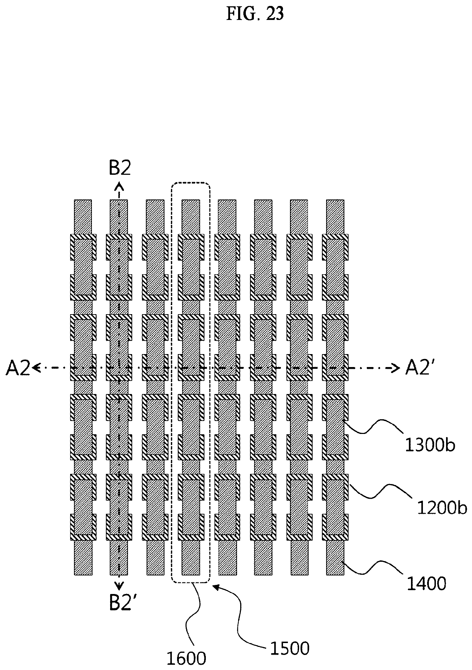

FIG. 21 is an assembled perspective view of one embodiment of the second example of the flexible thermoelectric module 1000 according to one exemplary embodiment of the present invention, and FIG. 22 is an exploded perspective view of one embodiment of the second example of the flexible thermoelectric module 1000 according to one exemplary embodiment of the present invention. FIG. 23 is a view illustrating arrangement and electrical connection of thermoelectric elements 1200 in one embodiment of the second example of the flexible thermoelectric module 1000 according to one exemplary embodiment of the present invention.

Referring to FIGS. 21 to 23, in this embodiment, the flexible thermoelectric module 1000 may have a plurality of thermoelectric elements 1200 arranged in a two-dimensional array. In the two-dimensional array, the thermoelectric elements 1200 may be arranged in a manner in which the first thermoelectric element 1200-1, for example, an N-type semiconductor, and the second thermoelectric element 1200-2, for example, a P-type semiconductor, are alternately arranged.

Here, the thermoelectric lines 1600 may be formed along direction B2-B2'. As described above, the thermoelectric line 1600 is formed by electrically connecting, in series, the thermoelectric elements 1200 that are spatially arranged in a line.

In this embodiment, the thermoelectric lines 1600 are not electrically connected to each other, but each of the thermoelectric lines forms one thermoelectric group 1500.

Specifically, each of the thermoelectric lines 1600 may be connected to the terminal 1400 at one end and to an adjacent thermoelectric line 1600 at the other end. Each thermoelectric group 1500 constituted by one thermoelectric line 1600 may independently perform an individual operation.

Accordingly, in this embodiment, the connector thermoelectric element 1200a is not provided. Nor is the connector electrode 1300a provided. All of the thermoelectric elements 1200 are the general thermoelectric elements 1200b, and all of the electrodes 1300 are the general electrodes 1300b. Accordingly, all of the electrodes 1300 included in the flexible thermoelectric module 1000 of this embodiment may be arranged such that the length direction thereof coincides with the arrangement direction of the thermoelectric line 1600.

Since the thermoelectric lines 1600 are not connected to each other but independently extend in direction B2-B2', the general electrodes 1300b connecting the thermoelectric elements 1200 in the respective thermoelectric lines 1600 are arranged such that the width direction thereof coincides with direction A2-A2'. Accordingly, in this embodiment, the cross section of the flexible thermoelectric module 1000 taken along A2-A2' may be similar to that of FIG. 16, and the cross section of the flexible thermoelectric module taken along B2-B2' may be similar to FIG. 17.

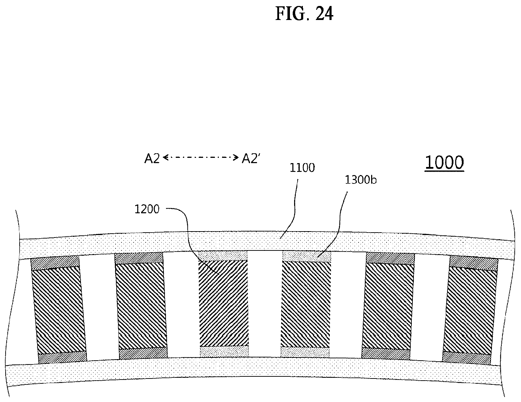

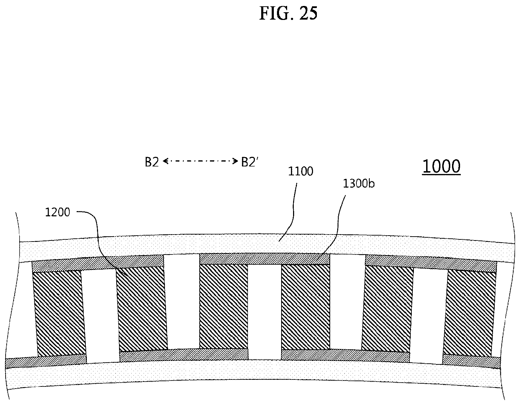

FIG. 24 is a view showing one embodiment of the second example of the flexible thermoelectric module 1000 according to one exemplary embodiment of the present invention that is curved along direction A2-A2', and FIG. 25 is a view showing one embodiment of the second example of the flexible thermoelectric module 1000 according to one exemplary embodiment of the present invention that is curved along direction B2-B2'.

Referring to FIG. 24, when the flexible thermoelectric module 1000 is curved in direction A2-A2', all the electrodes 1300 may be curved along the width direction thereof. Referring to FIG. 25, when the flexible thermoelectric module 1000 is curved in direction B2-B2', all the electrodes 1300 may be curved along the length direction thereof.

In this embodiment, all of the electrodes 1300 are the general electrode 1300b and are arranged such that the length direction thereof coincides with the arrangement direction of the thermoelectric line 1600. Therefore, it may be advantageous in terms of flexibility and durability of the thermoelectric module 1000 for the arrangement direction of the thermoelectric line 1600 to coincide with the curving direction.

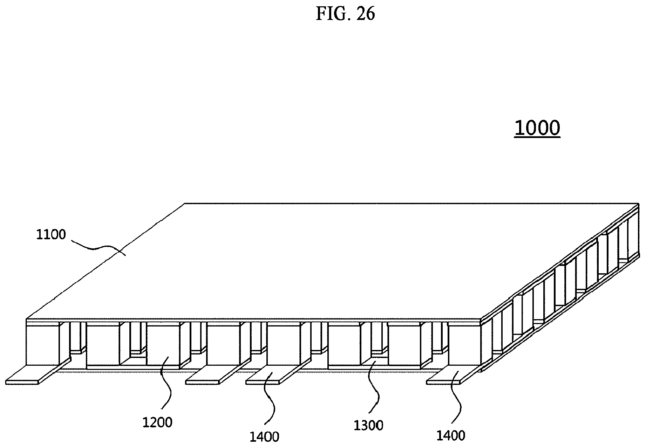

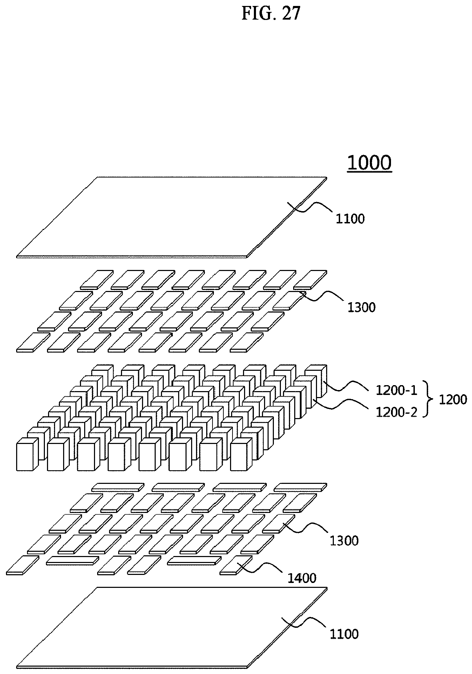

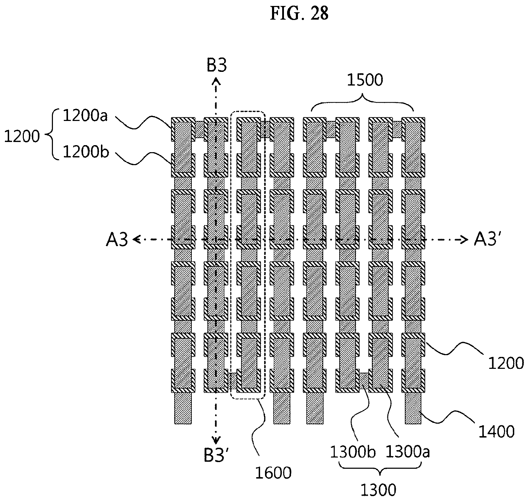

FIG. 26 is an assembled perspective view of another embodiment of the second example of the flexible thermoelectric module 1000 according to one exemplary embodiment of the present invention, and FIG. 27 is an exploded perspective view of another embodiment of the second example of the flexible thermoelectric module 1000 according to one exemplary embodiment of the present invention. FIG. 28 is a view illustrating arrangement and electrical connection of thermoelectric elements 1200 in another embodiment of the second example of the flexible thermoelectric module 1000 according to one exemplary embodiment of the present invention.

Referring to FIGS. 26 to 28, in this embodiment, the flexible thermoelectric module 1000 may have a plurality of thermoelectric elements 1200 arranged in a two-dimensional array. In the two-dimensional array, the thermoelectric elements 1200 may be arranged in a manner in which the first thermoelectric element 1200-1, for example, an N-type semiconductor, and the second thermoelectric element 1200-2, for example, a P-type semiconductor, are alternately arranged.

Here, the thermoelectric lines 1600 may be formed along direction B3-B3'. As described above, the thermoelectric line 1600 is formed by electrically connecting, in series, the thermoelectric elements 1200 that are spatially arranged in a line.

In this embodiment, some of the thermoelectric lines 1600 are electrically connected to each other to form a plurality of thermoelectric groups 1500. For example, n thermoelectric lines 1600 may be connected in series to form a plurality of thermoelectric groups 1500, where n is a natural number. In addition, the thermoelectric groups 1500 included in the flexible thermoelectric module 1000 of this embodiment may have the same number of thermoelectric lines 1600 or some or all of the thermoelectric groups 1500 may have a different number of thermoelectric lines 1600.

Specifically, among a predetermined number of thermoelectric lines 1600 continuously arranged, the thermoelectric lines 1600 except for the two thermoelectric lines 1600 located at the outermost positions along direction A3-A3' may be connected to one of two thermoelectric lines 1600 adjacent thereto at one end and connected to the other thermoelectric line 1600 of the two adjacent thermoelectric lines 1600 positioned on the opposite side to the one end in the arrangement direction of the thermoelectric line 1600.

Further, among a predetermined number of the thermoelectric lines 1600 arranged in succession, the two thermoelectric lines 1600 located at the outermost positions along the direction A3-A3' may be connected to the terminal 1400 at one end and connected to the thermoelectric lines 1600 adjacent thereto at the other end.

The thermoelectric lines 1600 on the two-dimensional array may form a plurality of thermoelectric groups 1500 in the above-described manner.

In this embodiment, the general electrodes 1300b in the thermoelectric line 1600, of which there are many, are arranged such that the width direction coincides with direction A3-A3', and the connector electrodes 1300a in the thermoelectric line 1600, of which there are few, are arranged such that the width direction thereof coincides with direction B3-B3'. Accordingly, in this embodiment, the cross section of the flexible thermoelectric module 1000 taken along A3-A3' may be similar to that of FIG. 16, and the cross section of the flexible thermoelectric module taken along B3-B3' may be similar to that of FIG. 17, regarding the general electrodes 1300b.

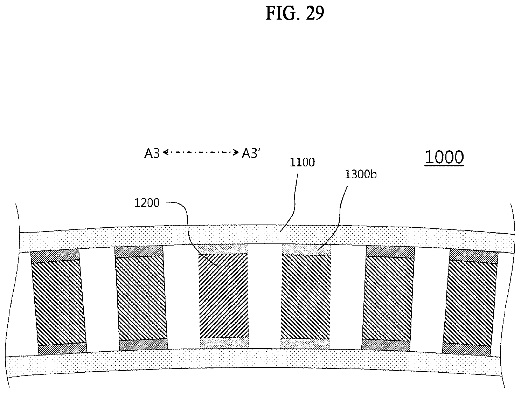

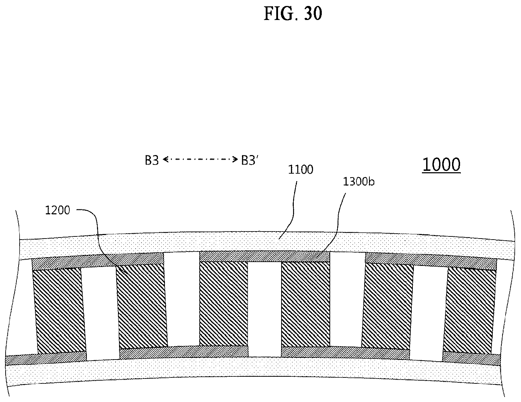

FIG. 29 is a view showing another embodiment of the second example of the flexible thermoelectric module 1000 according to one exemplary embodiment of the present invention that is curved along direction A3-A3', and FIG. 30 is a view showing another embodiment of the second example of the flexible thermoelectric module 1000 according to one exemplary embodiment of the present invention that is curved along direction B3-B3'.

Referring to FIG. 29, when the flexible thermoelectric module 1000 is curved in direction A3-A3', the plurality of electrodes 1300 may be curved along the width direction thereof. Referring to FIG. 30, when the flexible thermoelectric module 1000 is curved in direction B3-B3', the plurality of electrodes 1300 may be curved along the length direction thereof.

In this embodiment, the majority of the electrodes 1300 are general electrodes 1300b and are arranged such that the length direction thereof coincides with the arrangement direction of the thermoelectric line 1600. Accordingly, it may be advantageous in terms of flexibility and durability of the thermoelectric module 1000 for the arrangement direction of the thermoelectric line 1600 to coincide with the curving direction.

### 4. Flexible thermoelectric module with connector electrodes arranged on the same side

When the thermoelectric group 1500 in the flexible thermoelectric module 1000 is composed of a plurality of thermoelectric lines 1600, a part of the electrodes 1300 of the flexible thermoelectric module 1000 may serve as connector electrodes 1300a connecting the thermoelectric lines 1600. Here, the thermoelectric lines 1600 are electrically connected to each other, mainly through the connector electrodes 1300a located at the end of the thermoelectric lines 1600, and therefore the connector electrodes 1300a may be arranged along the arrangement direction of the electrical lines 1600 in both end regions of the thermoelectric lines 1600.

Generally, the electrodes 1300 forming the thermoelectric group 1500 in the flexible thermoelectric module 1000 are arranged alternately on both main surfaces of the flexible thermoelectric module 1000 according to the order thereof on the electric circuit.

On the other hand, when the number of the thermoelectric elements 1200 constituting the thermoelectric line 1600 is constant, the connector electrodes 1300a arranged at one end of the thermoelectric lines 1600 along the arrangement direction of the thermoelectric line 1600 may be arranged on the same main surface of the thermoelectric module 1000. The connector electrodes 1300a located at the opposite end of the thermoelectric lines 1600 may be arranged on the same main surface or the opposite main surfaces of the flexible thermoelectric module 1000, depending on whether the number of thermoelectric elements 1200 forming the thermoelectric line 1600 is an odd number or an even number. That is, by controlling the number of the thermoelectric elements 1200 constituting the thermoelectric line 1600, all the connector electrodes 1300a may be located on the same side.

When the connector electrodes 1300a are all located on the same side as described above, an advantageous effect may be obtained in terms of flexibility and durability in some usage modes of the flexible thermoelectric module 1000.

Hereinafter, representative examples of the flexible thermoelectric module 1000 having an arrangement of the connector electrodes 1300a that may be adapted to usage modes of the flexible thermoelectric module 1000 will be described.

It is to be noted that the following examples are merely intended to facilitate understanding of the present invention, and the present invention is not limited thereto.

In the following examples, the flexible thermoelectric module 1000 having any one of the layer structures of FIGS. 5 and 8 to 10 will be described. However, this is merely for convenience of explanation, and the flexible thermoelectric module 1000 in the following examples may have the layer structures of FIGS. 5 and 8 to 10 and other similar layer structures in addition to the layer structure employed for description.

That is, in the following examples, the layer structure of the flexible thermoelectric module 1000 can be combined, in various ways, with the arrangement of the thermoelectric elements 1200 and the electrodes 1300 that is made in consideration of the curving direction. Therefore, the present invention is not limited to the layer structure employed for the description. However, some of the examples described below may be related to the flexible thermoelectric module 1000 having a specific layer structure, which will be mentioned separately.

Further, in the following description, the end regions which are opposite to each other along the length direction of the thermoelectric line 1600 in the flexible thermoelectric module 1000 and where the connector electrodes 1300a and the terminals 1400 are arranged will be defined as "connection regions." In the case where the thermoelectric group 1500 consists of two thermoelectric lines 1600, the connector electrode 1300a may not be arranged in a region where the terminal 1400 is arranged in the flexible thermoelectric group 1500, but the region where the terminal 1400 is arranged will be referred to as a "connection region." Similarly, in the case where the thermoelectric group 1500 consists of a single thermoelectric line 1600, there may be no configuration corresponding to the connector electrode 1300a among the electrodes 1300 of the flexible thermoelectric group 1500, but the region where the terminal 1400 is arranged will be referred to as a "connection region."

It is to be noted that an arrangement of the connector electrodes 1300a that is made in consideration of the curving direction or the like may be combined with an arrangement of the thermoelectric elements 1200 and the electrodes 1300 that is made in consideration of the curving direction described above.

### 4.1. Flexible thermoelectric module having a connector electrode arranged on the exposed surface of the thermoelectric module

In the present example, the flexible thermoelectric module 1000 may be mounted on a thermoelectric apparatus 100 in such a manner that one of the two main surfaces thereof is exposed to the outside and the other main surface is not exposed to the outside. Hereinafter, the main surface exposed to the outside between the two main surface is referred to as an exposed surface, and the other main surface on the side opposite to the exposed surface is referred to as an unexposed surface.

Herein, the term "exposed to the outside" does not only mean direct exposure to the outside, but also includes indirect exposure. Accordingly, the exposed surface should be construed as a comprehensive term not only referring to a surface directly exposed to the outside but also including a surface that is indirectly exposed to the outside through a protective surface protecting the flexible thermoelectric module 1000 or the like. In the case where the both surfaces of the flexible thermoelectric module 1000 are exposed surfaces, the main surface that is more prone to breakage between the two main surfaces of the flexible thermoelectric module 1000 may be defined as an exposed surface, and the opposite surface may be defined as an unexposed surface.

In the present example, the connector electrodes 1300a arranged in the connection regions may be arranged on the unexposed surface side of the flexible thermoelectric module 1000.

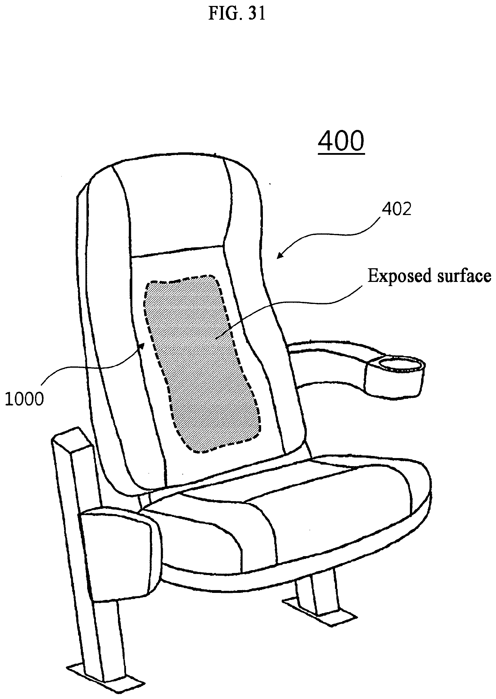

FIG. 31 is a view showing a thermoelectric apparatus 100 equipped with one embodiment of a third example of the flexible thermoelectric module 1000 according to one exemplary embodiment of the present invention.

Referring to FIG. 31, the flexible thermoelectric module 1000 may be mounted on the thermoelectric apparatus 100 such as a 4D experience seat 400 that provides a thermal sensation to a seated person when video content is output at a movie theater or the like. Here, the flexible thermoelectric module 1000 may be mounted on a seat portion 402 and may have an exposed surface and an unexposed surface.

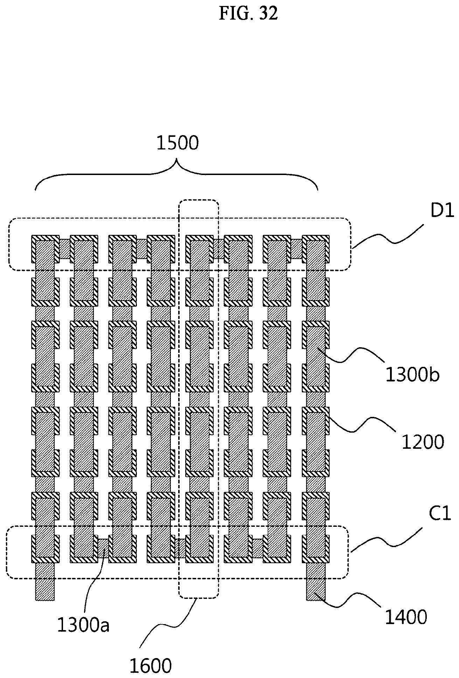

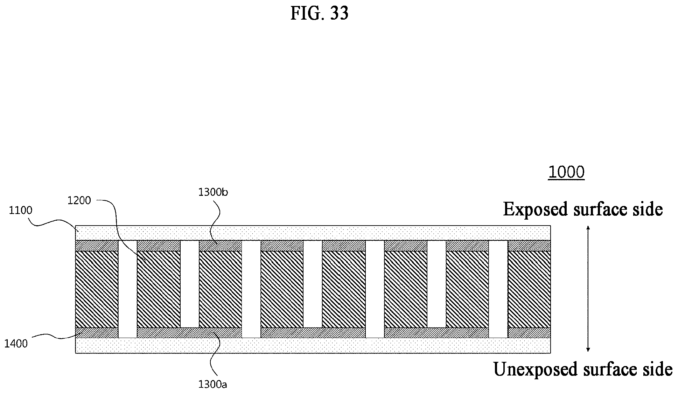

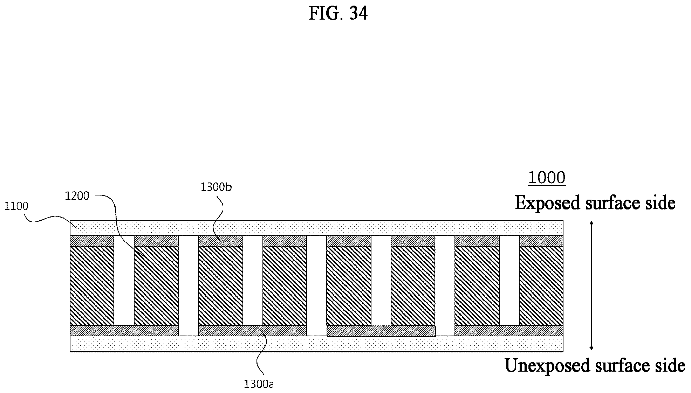

FIG. 32 is a view illustrating arrangement and electrical connection of thermoelectric elements 1200 in one embodiment of the third example of the flexible thermoelectric module 1000 according to one exemplary embodiment of the present invention. FIG. 33 is a cross-sectional view of region C1 of one embodiment of the third example of the flexible thermoelectric module 1000 according to one exemplary embodiment of the present invention, and FIG. 34 is a cross-sectional view of region D1 of one embodiment of the third example of the flexible thermoelectric module 1000 according to one exemplary embodiment of the present invention.

Referring to FIGS. 32 to 34, the flexible thermoelectric module 1000 may include a thermoelectric group 1500 having a plurality of thermoelectric lines 1600. Thus, the flexible thermoelectric module 1000 may have connection regions located from each other on the opposite sides along the length direction of the thermoelectric lines 1600.

In particular, it can be seen from FIGS. 33 and 34 that the connector electrodes 1300a in connection region C1, which is on the same side as the terminal 1400, and connection region D1, which is on the side opposite to the terminal 1400, are all arranged on the unexposed surface side of the flexible thermoelectric module 1000.

Referring again to FIG. 32, in order to arrange the connector electrodes 1300a of the two connection regions of the flexible thermoelectric module 1000 on the same side as described above, the number of the thermoelectric elements 1200 constituting the thermoelectric line 1600 may be set to 2m, where m is a natural number. That is, when the number of the thermoelectric elements 1200 of the thermoelectric line 1600 is 2m, the connector electrodes 1300a of the connection regions at both ends may be arranged to face in the same direction.

In order to arrange all the connector electrodes 1300a of the two connection regions of the flexible thermoelectric module 1000 on the unexposed surface side, the thermoelectric element 1200 leading to the terminal 1400 in the thermoelectric line 1600 may be connected to the terminal 1400 through one of both end surfaces of the thermoelectric element 1200 which is on the unexposed surface side.

However, in the case where the thermoelectric group 1500 is composed of two thermoelectric lines 1600, the connector electrode 1300a is not present in the connection region at the terminal 1400. In this case, the number of the thermoelectric elements 1200 constituting the thermoelectric line 1600 does not need to be set to 2m. For example, when the number of the thermoelectric elements 1200 constituting the thermoelectric line 1600 is 2m-1, the thermoelectric element 1200 leading to the terminal 1400 may be connected to the terminal 1400 through one of both end surfaces of the thermoelectric element 1200 which is on the unexposed surface side. Thereby, even when the number of the thermoelectric elements 1200 constituting the thermoelectric line 1600 is 2m-1, all the connector electrodes 1300a may be arranged on the unexposed surface side.

Accordingly, when the number of the thermoelectric elements 1600 constituting the thermoelectric group 1500 is two, whether to arrange the terminal 1400 on the exposed surface side or the unexposed surface side may be determined by adjusting the number of the thermoelectric elements 1200 while the connector electrodes 1300a are positioned on the unexposed surface side. Generally, it may be advantageous in terms of durability and the like for the terminal 1400 to be located on the unexposed surface side. However, considering maintenance or spatial design, it may be advantageous for the terminal 1400 to be exposed to the outside.

In an environment where the flexible thermoelectric module 1000 is used mainly in a curved shape, poor contact between, or breakage of, the thermoelectric elements 1200 and the electrodes 1300 is more likely to occur as compared with the case of the conventional non-flexible thermoelectric module. This issue is likely to be raised due to the connector electrodes 1300a rather than the general electrodes 1300b which are alternately arranged on the exposed surface side and the unexposed surface side of the flexible thermoelectric module 1000. In particular, when the connector electrodes 1300a are arranged such that the length direction thereof coincides with the curving direction, the possibility of occurrence of a problem in the connector electrodes 1300a may further increase.

When the connector electrodes 1300a are arranged as close to the unexposed surface side as possible as in the present example such that the connector electrodes 1300a are protected to a maximum degree by the substrate 1100 or the like, the failure of the connector electrodes 1300a may be suppressed as much as possible.

In the above description, the arrangement and the electrical connection of the thermoelectric elements 1200 have been disclosed on the condition that the thermoelectric lines 1600 have the same number of the thermoelectric elements 1200. According to the description, when the thermoelectric group 1500 is composed of a plurality of thermoelectric lines 1600, the terminal 1400 and the connector electrodes 1300a which are in the same connection region are located on the same side of the flexible thermoelectric module 1000. However, it some cases, it may be necessary to locate, on different main surfaces of the flexible thermoelectric module 1000, the terminal 1400 and the connector electrodes 1300a which are in the same connection region.

For example, the connector electrodes 1300a may need to be located on the unexposed surface side in both connection regions in order to prevent breakage of the connector electrodes 1300a. The terminal 1400 may need to be located on the exposed surface side due to the wiring design. In this case, the number of thermoelectric elements 1200 of the thermoelectric line 1600 connected to the terminal 1400 among the thermoelectric lines 1600 constituting the thermoelectric group 1500 may be set to be different from the number of thermoelectric elements in the other thermoelectric lines 1600. Thereby, the connector electrodes 1300a and the terminal 1400 may be arranged on the different main surfaces of the flexible thermoelectric module 1000. Specifically, when the number of thermoelectric elements 1200 in the thermoelectric line 1600 to which the terminal 1400 belongs is set to 2m-1 and the number of thermoelectric elements 1200 in the other thermoelectric lines 1600 is set to 2m, the terminal 1400 may be located on the exposed surface side of the flexible thermoelectric module 1000, and the connector electrodes 1300a in both connection regions may all be located on the unexposed surface side of the flexible thermoelectric module 1000.

### 4.2. Flexible thermoelectric module having connector electrodes arranged on an outer-diameter surface side of the flexible thermoelectric module in a curved shape

In the present example, the flexible thermoelectric module 1000 may be mounted on the thermoelectric apparatus 100 such that one of both main surfaces of the flexible thermoelectric module 1000 faces a center of curvature and the other main surface is opposite to the surface facing the center of curvature. Hereinafter, between both of the main surfaces, the one main surface facing the center of curvature of the main surface will be referred to as an inner surface, and the other main surface opposite to the inner surface will be referred to as an outer surface.

Herein, the inner surface and the outer surface are terms different from the exposed surface and the unexposed surface described above. That is, when the flexible thermoelectric module 1000 is applied to a thermoelectric apparatus 100 having a convex outer shape like the stick type gaming controller shown in FIG. 3, the outer-diameter surface is the exposed surface and the inner-diameter surface is the unexposed surface. In contrast, when the flexible thermoelectric module 1000 is applied to a thermoelectric apparatus 100 having a concave outer shape, the outer-diameter surface may be the unexposed surface and the inner-diameter surface may be the exposed surface.

In the present example, the connector electrodes 1300a arranged in the connection regions may be arranged on the outer-diameter surface side of the flexible thermoelectric module 1000.

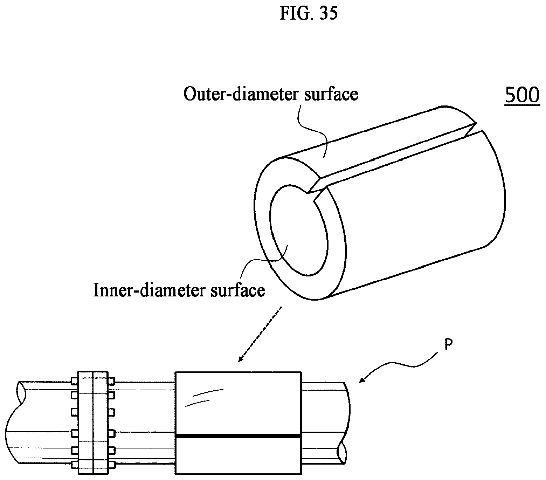

FIG. 35 is a view showing a thermoelectric apparatus equipped with another embodiment of the third example of the flexible thermoelectric module 1000 according to one exemplary embodiment of the present invention.

Referring to FIG. 35, the flexible thermoelectric module 1000 may be mounted on a thermoelectric apparatus 100 such as a waste heat generator 500 or a temperature sensing device 500 installed on a pipeline P of a factory. In the thermoelectric apparatus 100 as shown in FIG. 35, the flexible thermoelectric module 1000 may be installed so as to surround the pipeline and thus may produce electric energy using the temperature difference between the pipeline and the external air or sense the temperature of the pipeline based on the voltage of the produced electric energy or the like. Here, the flexible thermoelectric module 1000 may have an outer-diameter surface, which is a convex surface, and an inner-diameter surface, which is a concave surface.

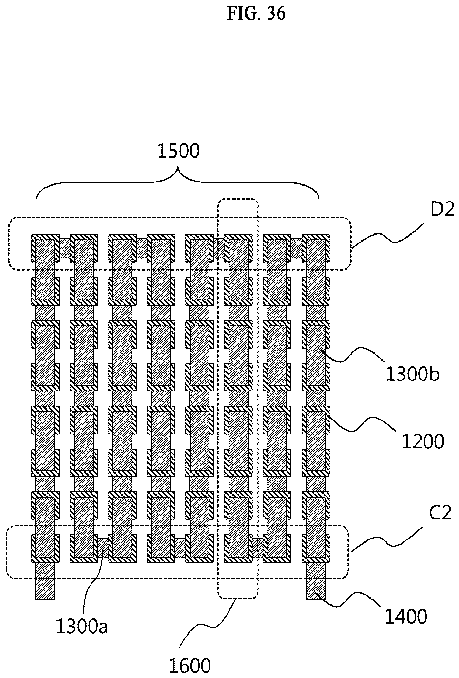

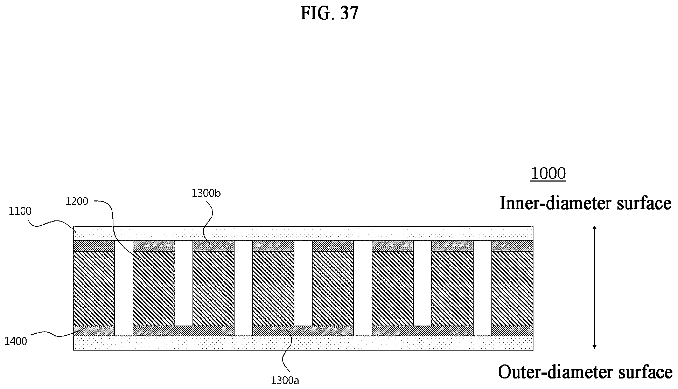

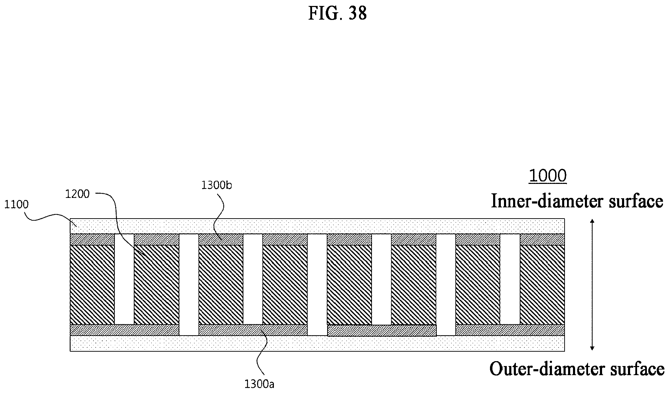

FIG. 36 is a view illustrating arrangement and electrical connection of thermoelectric elements 1200 in another embodiment of the third example of the flexible thermoelectric module 1000 according to one exemplary embodiment of the present invention. FIG. 37 is a cross-sectional view of region C2 of another embodiment of the third example of the flexible thermoelectric module 1000 according to one exemplary embodiment of the present invention, and FIG. 38 is a cross-sectional view of region D2 of another embodiment of the third example of the flexible thermoelectric module 1000 according to one exemplary embodiment of the present invention.

Referring to FIGS. 36 to 38, the flexible thermoelectric module 1000 may include a thermoelectric group 1500 having a plurality of thermoelectric lines 1600. Thus, the flexible thermoelectric module 1000 may have connection regions located from each other on the opposite sides along the length direction of the thermoelectric lines 1600.

In particular, it can be seen from FIGS. 37 and 38 that the connector electrodes 1300a in connection region C2, which is at the terminal 1400, and connection region D2, which is on the side opposite to the terminal 1400, are all arranged on the outer-diameter surface side of the flexible thermoelectric module 1000.

Referring again to FIG. 36, in order to arrange the connector electrodes 1300a of the two connection regions of the flexible thermoelectric module 1000 on the same side as described above, the number of the thermoelectric elements 1200 constituting the thermoelectric line 1600 may be set to 2m, where m is a natural number. That is, when the number of the thermoelectric elements 1200 of the thermoelectric line 1600 is 2m, the connector electrodes 1300a of the connection regions at both ends may be arranged to face in the same direction.

In order to arrange all the connector electrodes 1300a of the two connection regions of the flexible thermoelectric module 1000 on the outer-diameter surface, the thermoelectric element 1200 leading to the terminal 1400 in the thermoelectric line 1600 may be connected to the terminal 1400 through one of both end surfaces of the thermoelectric element 1200 which is on the outer-diameter surface side.

However, in the case where the thermoelectric group 1500 is composed of two thermoelectric lines 1600, the connector electrode 1300a is not present in the connection region at the terminal 1400. In this case, the number of the thermoelectric elements 1200 constituting the thermoelectric line 1600 does not need to be set to 2m. For example, when the number of the thermoelectric elements 1200 constituting the thermoelectric line 1600 is 2m-1, the thermoelectric element 1200 leading to the terminal 1400 may be connected to the terminal 1400 through one of both end surfaces of the thermoelectric element 1200 which is on the inner-diameter surface side. Thereby, even when the number of the thermoelectric elements 1200 constituting the thermoelectric line 1600 is 2m-1, all the connector electrodes 1300a may be arranged on the outer-diameter surface side.

In an environment where the flexible thermoelectric module 1000 is used mainly in a curved shape, poor contact between or breakage of the thermoelectric elements 1200 and the electrodes 1300 are likely to occur as compared with the case of the conventional non-flexible thermoelectric module. The flexible thermoelectric module 1000 generally has a thickness smaller than the other dimensions such as a length and a width. However, when the flexible thermoelectric module 1000 is curved at a certain angle or more, the difference in the radius of curvature between the outer-diameter surface and the inner-diameter surface may have a significant effect thereon. In particular, the electrode 1300 may be formed of a material having a relatively low flexibility, unlike the substrate 1100, which is formed of a material having a high flexibility. Accordingly, in order to minimize the adverse effect of the low flexibility of the electrodes 1300 on the flexibility of the entire flexible thermoelectric module 1000, the electrodes 1300 may be arranged on the outer-diameter surface having a comparatively large radius of curvature, namely, a comparatively small curving angle rather than on the inner-diameter surface having a comparatively small radius of curvature, namely, a comparatively large curving angle. Thereby, the flexibility of the entire flexible thermoelectric module 1000 may be enhanced. The connector electrodes 1300a are generally arranged in a line in the connection region. When the connector electrodes 1300a are arranged on the inner-diameter surface having a large curving angle, the connector electrodes 1300a are curved at a large angle. This arrangement may result in breakage of portions soldered with the thermoelectric elements 1200 as well as a short circuit through contact between adjacent connector electrodes 1300a. Accordingly, the above-mentioned problems may be alleviated when the connector electrodes 1300a are arranged on the outer-diameter surface as in the present example.

The present example may be combined with the example of the flexible thermoelectric module 1000 in which the connector electrodes 1300a are arranged on the unexposed surface. For example, when the exposed surface is concave, the outer-diameter surface and the unexposed surface are the same. In this case, by arranging the connector electrodes 1300a on a main surface which is the outer-diameter surface and unexposed surface, an advantage obtained when the connector electrodes 1300a are arranged on the outer-diameter surface and an advantage obtained when the connector electrodes 1300a are arranged on the unexposed surface may be obtained together. Of course, when the exposed surface is a convex surface, the present example or the unexposed surface may be properly selected for arrangement of the connector electrodes 1300a.

### 4.3. Flexible thermoelectric module having connector electrodes arranged on the side facing the outer substrate of the flexible thermoelectric module

In the present example, the flexible thermoelectric module 1000 having the outer substrate 1120 on only one of the two main surfaces of the flexible thermoelectric module 1000 shown in FIG. 9 will be described. However, the present example is not limited to the flexible thermoelectric module 1000 having the layer structure of FIG. 9 and may be applied to other layer structures as well, which will be described in detail later.

Referring to FIG. 9, the layer structure of the flexible thermoelectric module 1000 has an outer substrate 1120 only on one side of the inner substrate 1140. This is because the outer substrate 1120 is flexible to a certain degree but providing the outer substrate 1120 on only one of the two main surfaces of the inner substrate 1140 is more advantageous than providing the outer substrate 1120 on both main surfaces of the inner substrate 1140 in terms of flexibility of the flexible thermoelectric module 1000.

In the present example, the connector electrodes 1300a arranged in the connection regions may be arranged between the inner substrate 1140 and the outer substrate 1120 of the flexible thermoelectric module 1000.

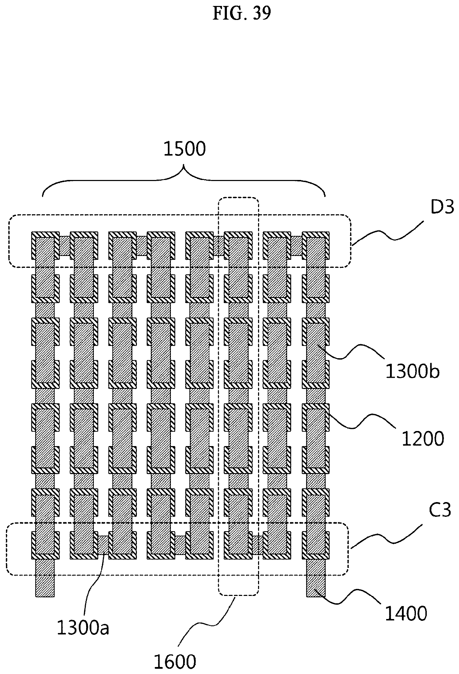

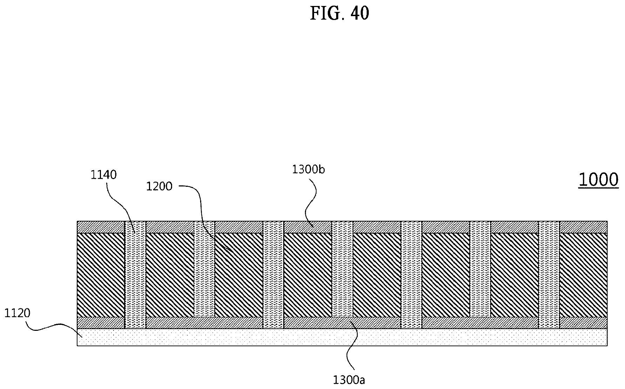

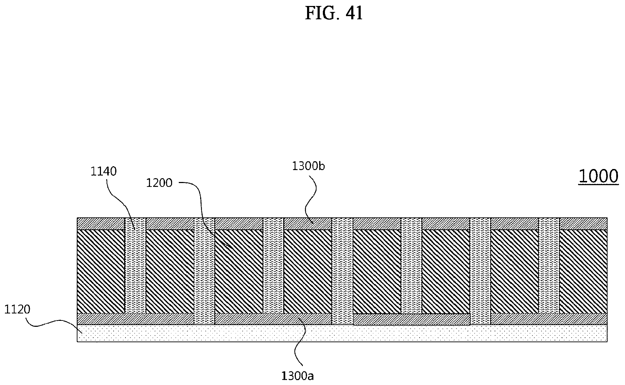

FIG. 39 is a view illustrating arrangement and electrical connection of thermoelectric elements 1200 in still another embodiment of the third example of the flexible thermoelectric module 1000 according to one exemplary embodiment of the present invention. FIG. 40 is a cross-sectional view of region C3 of still another embodiment of the third example of the flexible thermoelectric module 1000 according to one exemplary embodiment of the present invention, and FIG. 41 is a cross-sectional view of region D3 of still another embodiment of the third example of the flexible thermoelectric module 1000 according to one exemplary embodiment of the present invention.

Referring to FIGS. 39 to 41, the flexible thermoelectric module 1000 may include a thermoelectric group 1500 having a plurality of thermoelectric lines 1600. Accordingly, the flexible thermoelectric module 1000 may have connection regions located form each other on the opposite sides along the length direction of the thermoelectric lines 1600.

In particular, it can be seen from FIGS. 40 and 41 that all the connector electrodes 1300a in connection regions C3 and D3 of the flexible thermoelectric module 1000 are arranged on a side on which the external substrate 1120 of the outer thermoelectric module 1000 is arranged.

Referring again to FIG. 39, in order to arrange the connector electrodes 1300a of the two connection regions of the flexible thermoelectric module 1000 on the same side as described above, the number of the thermoelectric elements 1200 constituting the thermoelectric line 1600 may be set to 2m, where m is a natural number. That is, when the number of the thermoelectric elements 1200 of the thermoelectric line 1600 is 2m, the connector electrodes 1300a of the connection regions at both ends may be arranged to face in the same direction.

In order to arrange all the connector electrodes 1300a of the two connection regions of the flexible thermoelectric module 1000 between the inner substrate 1140 and the outer substrate 1120, the thermoelectric element 1200 leading to the terminal 1400 in the thermoelectric line 1600 may be connected to the terminal 1400 from the inner substrate 1140 through one of both end surfaces of the thermoelectric element 1200 on the side where the outer substrate 1120 is present.

However, in the case where the thermoelectric group 1500 is composed of two thermoelectric lines 1600, the connector electrode 1300a is not present in the connection region at the terminal 1400. In this case, the number of the thermoelectric elements 1200 constituting the thermoelectric line 1600 does not need to be set to 2m. For example, when the number of the thermoelectric elements 1200 constituting the thermoelectric line 1600 is 2m-1, the thermoelectric element 1200 leading to the terminal 1400 may be connected to the terminal 1400 through one of both end surfaces of the thermoelectric element 1200 which is on the side where the outer substrate 1120 is not present. Thereby, even when the number of the thermoelectric elements 1200 constituting the thermoelectric line 1600 is 2m-1, all the connector electrodes 1300a may be arranged between the outer substrate 1120 and the inner substrate 1140.

In an environment where the flexible thermoelectric module 1000 is used mainly in a curved shape, poor contact between or breakage of the thermoelectric elements 1200 and the electrodes 1300 are likely to occur as compared with the case of the conventional non-flexible thermoelectric module. In the case of the flexible thermoelectric module 1000 in which the outer substrate 1120 is arranged only on one side of the inner substrate 1140, the electrodes 1300 arranged between the outer substrate 1120 and the inner substrate 1140 may be stably supported because the electrodes 1300 are supported by the outer surface of the inner substrate 1140 and the inner surface of the outer substrate 1120. However, the electrodes 1300 arranged on the side where the outer substrate 1120 is not provided may be supported relatively unstably because the electrodes 1300 are supported only by the inner substrate 1140. Particularly, when the flexible thermoelectric module 1000 is curved, the connector electrodes 1300a may be subjected to a large stress. In the present example, the connector electrodes 1300a are all arranged between the inner substrate 1140 and the outer substrate 1120. Therefore, the connector electrodes 1300a may be more stably supported.

The present example can be combined with at least one of the example of the flexible thermoelectric module 1000 in which the connector electrodes 1300a are arranged on the unexposed surface and the example of the flexible thermoelectric module 1000 in which the connector electrode 1300a is arranged on the outer surface. For example, when a surface of the flexible thermoelectric module 1000 on the side where the outer substrate 1120 is present is used as an unexposed surface, an advantage obtained when the connector electrodes 1300a are arranged on the unexposed surface and an advantage obtained when the connector electrodes 1300a are arranged between the outer substrate 1120 and the inner substrate 1140 may be obtained together. As another example, when the surface of the flexible thermoelectric module 1000 on the side where the outer substrate 1120 is present is used as a convex surface, an advantage obtained when the connector electrodes 1300a are arranged on the outer-diameter surface and an advantage obtained when the connector electrodes 1300a are arranged between the outer substrate 1120 and the inner substrate 1140 may be obtained together.

Alternatively, the present example may be used to overcome the drawbacks of the example of the flexible thermoelectric module 1000 in which the connector electrodes 1300a are arranged on the unexposed surface and the example of the flexible thermoelectric module 1000 in which the connector electrode 1300a is arranged on the outer surface. For example, when the surface of the flexible thermoelectric module 1000 on the side where the outer substrate 1120 is present is used as an exposed surface, the outer substrate 1120 may stably support the connector electrodes 1300a although the connector electrodes 1300a are arranged on the exposed surface. As another example, when the surface of the flexible thermoelectric module 1000 on the side where the outer substrate 1120 is present is used as an inner-diameter surface, the outer substrate 1120 may stably support the connector electrodes 1300a although the connector electrodes 1300a are arranged on the inner-diameter surface.

In the foregoing, the present example has been described based on the layer structure of the flexible thermoelectric module 1000 shown in FIG. 9. However, the present example may be applied to layer structures other than the layer structure of FIG. 9.

As an example, in the case of the flexible thermoelectric module 1000 having the layer structure as shown in FIG. 5 or 8 in which the outer substrates 1120 are provided on both main surfaces of the flexible thermoelectric module 1000, the connector electrodes 1300a may be arranged on the side facing the outer substrate 1120 that may better support the electrodes 1300 between the two outer substrates 1120. Specifically, when the materials of the two outer substrates 1120 are different from each other, the connector electrodes 1300a may be arranged on the side facing the outer substrate 1120 that has higher flexibility or higher adhesiveness to electrodes 1300 and thus may more stably support the electrodes 1300 between the two outer substrates 1120. In other words, as a variation of the present example, the connector electrodes 1300a in the flexible thermoelectric module 1000 may be arranged on the side facing of the outer substrate 1120 that has higher supportability for the electrodes 1300 between the two outer substrates 1120.

As another example, in the case of the flexible thermoelectric module 1000 having the layer structure without the outer substrate 1120 as shown in FIG. 10, the connector electrodes 1300a may be arranged on the side facing a main surface that may better support the electrodes 1300 between the two main surfaces. In other words, as a variation of the present example, the connector electrodes 1300a in the flexible thermoelectric module 1000 may be arranged on the side facing one of the two main surfaces of the inner substrate 1140 that has higher supportability.

As still another example, in the case where a heat dissipation device such as a heat sink, a heat pipe, a heat dissipation fin, or the like is installed on one side of the two main surfaces of the flexible thermoelectric module 1000, or in the case where one side of the two main surfaces of the flexible thermoelectric module 1000 is supported by the casing of the thermoelectric apparatus 100 or the like, the connector electrodes 1300a may be arranged on the side of the two main surfaces where the heat dissipation device is located or which is supported by the casing of the thermoelectric apparatus 100. In other words, as a variation of the present example, the connector electrodes 1300a in the flexible thermoelectric module 1000 may be arranged on the side of the two main surfaces of the flexible thermoelectric module 1000 facing an external component such as a heat dissipation device, the casing of the thermoelectric apparatus 100, or the like.

### 5. Flexible thermoelectric module with an arrangement of connectors and connector electrodes in consideration of radius of curvature

Hereinafter, the flexible thermoelectric module 1000 used in a curved shape having a variable radius of curvature will be described.

In FIGS. 3 and 4, the flexible thermoelectric module 1000 has been described as being used for a cylindrical curved surface having a constant curvature. However, the flexible thermoelectric module 1000 may not necessarily be used in a cylindrical curved surface having a constant curvature.

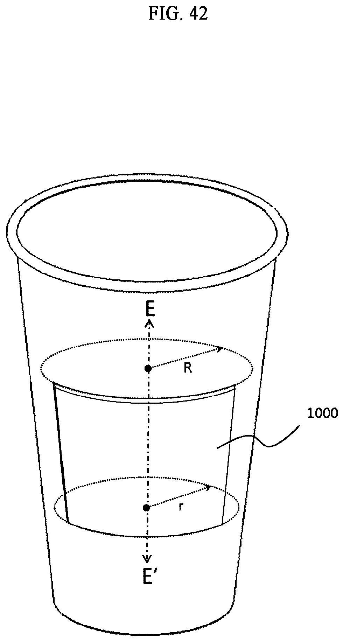

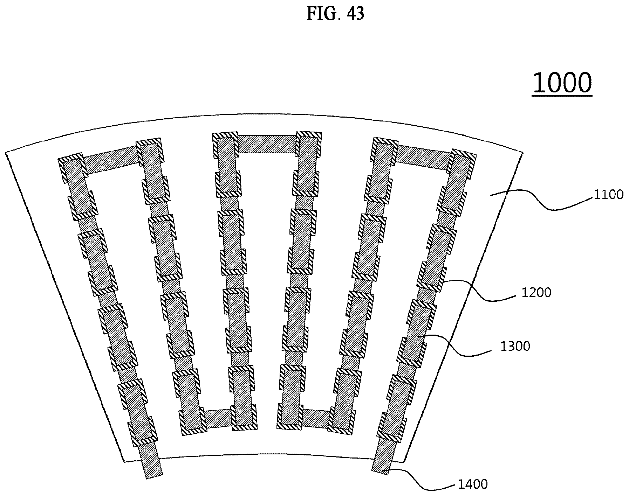

FIG. 42 is a view of a thermoelectric apparatus 100 equipped with a fourth example of the flexible thermoelectric module 1000 according to one exemplary embodiment of the present invention, and FIG. 43 is a view illustrating arrangement and electrical connection of thermoelectric elements 1200 in the fourth example of the flexible thermoelectric module according to one exemplary embodiment of the present invention.

Referring to FIG. 42, in the present example, the flexible thermoelectric module 1000 may be mounted on a portion of the thermoelectric apparatus 100 where the curvature changes along direction E-E'. Referring to FIG. 42, a radius of curvature r in a lower region of the flexible thermoelectric module 1000 is smaller than a radius of curvature R in an upper region. That is, the flexible thermoelectric module 1000 may be gently curved at the upper portion and sharply curved at the lower portion. Referring to FIG. 43, the flexible thermoelectric module 1000 of the above-described type may have fan-shaped main surfaces.

In the present example, a connection region of the flexible thermoelectric module 1000 that has a larger number of connector electrodes 1300a in the other connection region may be arranged at the large-diameter portion.

Herein, the "large-diameter portion" is a region having a large radius of curvature when the flexible thermoelectric module 1000 is curved with a radius of curvature that is not constant for each region, that is, a region which has a small curving angle. In contrast, a region having a small radius of curvature when the flexible thermoelectric module 1000 is curved with a radius of curvature that is not constant for each region, that is, a region which has a sharp curving angle will be referred to as a "small-diameter portion."

While FIGS. 42 and 43 illustrate that the large-diameter portion and the small-diameter portion are located at both edges of the main surface of the flexible thermoelectric module 1000, it should be noted that the positions of the large-diameter portion and the small-diameter portion are not limited to those shown in FIGS. 42 and 43.

As described above, the flexible thermoelectric module 1000 may be arranged such that the length direction of the electrodes 1300 included in the flexible thermoelectric module 1000 is as perpendicular to the curving direction as possible. Accordingly, in the present example, the electrodes may be arranged such that the length direction of the general electrodes 1300b is perpendicular to the curving direction and the length direction of the connector electrodes 1300a coincides with the curving direction. Accordingly, the connection region may be located at each of the large-diameter portion and the small-diameter portion of the flexible thermoelectric module 1000.

The connection region is divided into a connection region in which the terminal 1400 is located and a connection region in which the terminal 1400 is not located. Regarding the two connection regions, the number of connector electrodes 1300a belonging to the connection region in which the terminal 1400 is not located may be greater than the number of connector electrodes 1300a belonging to the connection region in which the terminal 1400 is located. In particular, as the number of thermoelectric lines 1600 constituting the thermoelectric group 1500 decreases, the ratio of the numbers of the connector electrodes 1300a in the two connection regions may increase. For example, when the thermoelectric group 1500 includes two thermoelectric lines 1600, the connector electrode 1300a may not be present in the connection region at the terminal 1400. As another example, when the thermoelectric group 1500 includes four thermoelectric lines 1600, the number of connector electrodes 1300a belonging to the connection region on the side where the terminal 1400 is not present may be twice the number of thermoelectric electrodes 1300 belonging to the connection region on the side where the terminal 1400 is present.

As described above, the connector electrode 1300a arranged such that the length direction thereof coincides with the curving direction not only degrades the flexibility of the flexible thermoelectric module 1000 but also is prone to breakage. This issue may be addressed by decreasing the curving angle of the connector electrodes 1300a.

Accordingly, in the flexible thermoelectric module 1000 having a large-diameter portion and a small-diameter portion as in the present example, the connection region having a greater number of connector electrodes 1300a than the other connection region may be arranged at the large-diameter portion, thereby improving the flexibility and durability of the flexible thermoelectric module 1000.

The present example may be combined with at least one of the examples of the layer structures of the flexible thermoelectric module 1000, the examples of the flexible thermoelectric module 1000 having an arrangement of the thermoelectric elements 1200 and the electrodes 1300 in consideration of the curving direction, and the examples of the flexible thermoelectric module 1000 having the connector electrodes 1300a on the same side described above.

### 6. Flexible thermoelectric module having a connection region located at the center of the main surface

For the flexible thermoelectric module 1000 described above, it has been described that the connection regions of the flexible thermoelectric module 1000 are formed in both edge regions of the flexible thermoelectric module 1000 in the direction perpendicular to the arrangement direction of the thermoelectric line 1600. Alternatively, by designing the arrangement and electrical connection of the thermoelectric elements 1200 in the flexible thermoelectric module 1000, the connection region may be formed at a portion (hereinafter referred to as a "central region") different from the edge regions of the flexible thermoelectric module 1000.

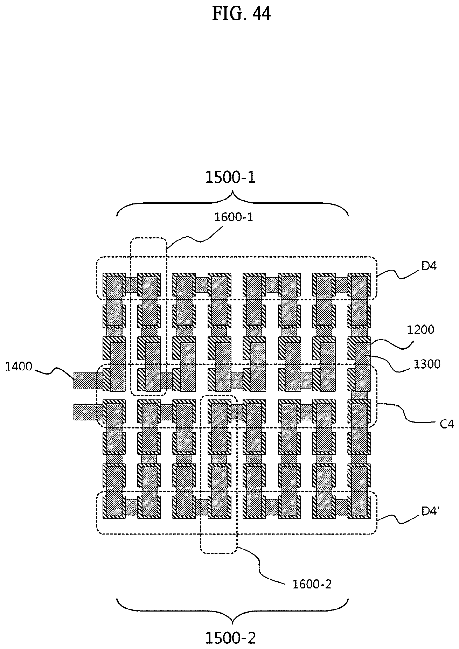

FIG. 44 is a view illustrating arrangement and electrical connection of thermoelectric elements 1200 in a fifth example of the flexible thermoelectric module 1000 according to one exemplary embodiment of the present invention.

Referring to FIG. 44, three connection regions may be formed in both edge regions D4 and D4' and central region C4 in the flexible thermoelectric module 1000. Here, the thermoelectric lines 1600 constituting the thermoelectric group 1500 may be formed on both sides of central region C4. In the present example, for convenience of description, the thermoelectric lines 1600 on one side of central region C4 are referred to as first thermoelectric lines 1600-1 and the thermoelectric lines 1600 on the other side of central region C4 are referred to as second thermoelectric lines 1600-2.

The first thermoelectric lines 1600-1 may be connected in series to each other through connection region D4 at the edge on one side and connection region C4 at the center to form a first thermoelectric sub-group 1500-1. Similarly, the second thermoelectric lines 1600-2 may be connected in series to each other through connection region D4' at the edge on the other side and connection region C4 at the center to form a second thermoelectric sub-group 1500-2. The first thermoelectric sub-group 1500-1 may be connected to the terminal 1400 through the thermoelectric element 1200 located at one end of the electric circuit thereof and connected to the second thermoelectric sub-group 1500-2 through the thermoelectric element 1200 located at the other end. Similarly, the second sub-thermoelectric group 1500-2 may be connected to the terminal 1400 through the thermoelectric element 1200 located at one end of the electric circuit thereof and connected to the first thermoelectric sub-group 1500-1 through the thermoelectric element 1200 located at the other end. Thus, the first thermoelectric sub-group 1500-1 and the second thermoelectric sub-group 1500-2 may be electrically connected to each other to form one thermoelectric group 1500.

In other words, in the present example, a pair of thermoelectric groups 1500-1 and 1500-2 including a plurality of thermoelectric lines 1600 arranged along one direction form one thermoelectric group 1500 by sharing a connection region in the central region.

The flexible thermoelectric module 1000 having the thermoelectric group 1500 including the thermoelectric sub-groups 1500-1 and 1500-2 described in this example has the terminals 1400 concentrated in the central region and therefore facilitates wiring. Further, the flexible thermoelectric module 1000 is suitable for a usage mode of curving to both sides of the central connection region.

### 7. Flexible thermoelectric module used for a complex curved surface

In the above, the flexible thermoelectric module 1000 which is mainly curved into a simple curved shape has been described. The flexible thermoelectric module 1000 of the present invention may be used in a complex three-dimensional curved shape. However, it may be difficult to deform the flexible thermoelectric module 1000 manufactured in a flat plate shape into a complex curved surface. Even if the flexible thermoelectric module 1000 having a flat plate shape is mounted on a thermoelectric apparatus 100 in a complex curved shape, the density of the thermoelectric elements 1200 per unit area of the thermoelectric apparatus 100 may not be uniform.

Considering that it is difficult to deform the flexible thermoelectric module 1000 manufactured using the plate-shaped substrate 1100 into a complex curved shape and it is difficult to maintain a constant number of thermoelectric elements 1200 per unit area, the present applicant has devised a flexible thermoelectric module 1000 using a substrate 1100 compartmentalized into multiple sub-substrates 1160 by cutting the substrate 1100 in the direction of the thermoelectric lines 1600.

Here, the layer of the substrate 1100 compartmentalized into the multiple sub-substrates 1160 may be provided in various forms including the above-described examples relating to the layer structures. In other words, since the present example relates to the shape of the substrate 1100 viewed from above the main surface of the flexible thermoelectric module 1000, the substrate 1100 is not limited to a specific layer structure in the present example.

Hereinafter, a flexible thermoelectric module 1000 that may be used for a complex curved surface will be described.

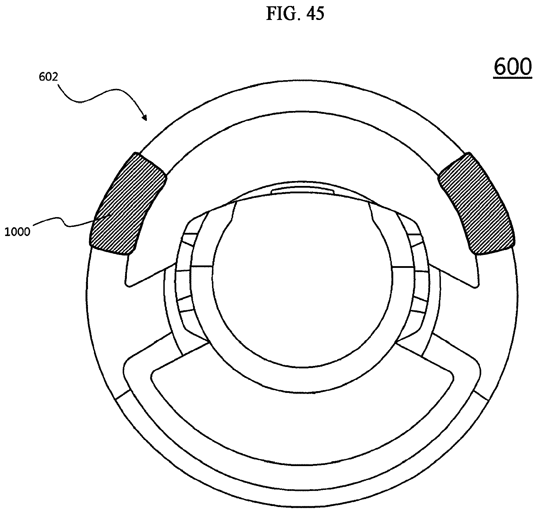

FIG. 45 is a view showing a thermoelectric apparatus 100 equipped with one embodiment of a sixth example of the flexible thermoelectric module 1000 according to one exemplary embodiment of the present invention.

FIG. 45 illustrates that the flexible thermoelectric module 1000 is mounted on a thermoelectric apparatus 100 such as a steering wheel 600 of a vehicle. A grip portion 602 of the steering wheel has a complex curved surface having a rim shape and a circular or oval cross section. It may be difficult to install the flexible thermoelectric module 100 with the substrate 1100 having a typical flat shape as described above on the complex curved surface.

On the contrary, the flexible thermoelectric module 1000 according to the present example may be installed on the complex curved surface described above.

In the present example, the substrate 1100 may be compartmentalized into a plurality of sub-substrates 1160. One or more thermoelectric lines 1600 may be provided on each of the sub-substrates 1160. The sub-substrate 1160 may extend along the extending direction of the thermoelectric line 1600 to provide a space in which the thermoelectric elements 1200 constituting the thermoelectric line 1600 are arranged.

The sub-substrate 1160 may be connected to an adjacent sub-substrate 1160 at one end of the length direction extending along thermoelectric line 1600. The substrate 1100 of the flexible thermoelectric module 1000 may be formed according to the connection between the adjacent sub-substrates 1160.

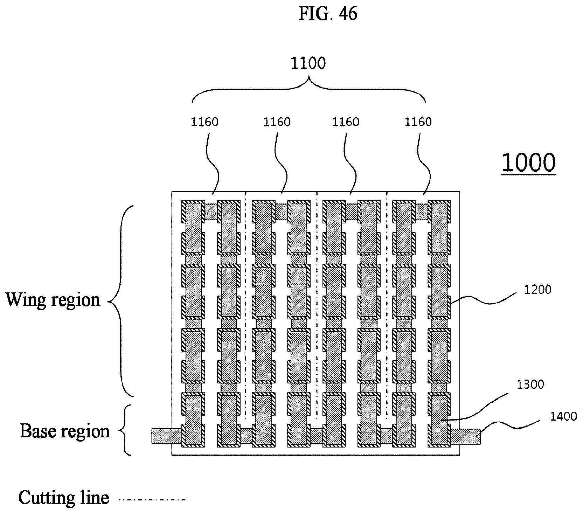

FIG. 46 is a plan view of one embodiment of the sixth example of the flexible thermoelectric module 1000 according to one exemplary embodiment of the present invention.

Referring to FIG. 46, according to one embodiment, the sub-substrates 1160 may be connected to each other at the same end of both ends along the extending direction of the thermoelectric lines 1600. In this case, the outermost sub-substrates 1160 among the sub-substrates 1160 may be connected to the terminals 1400 instead of adjacent sub-substrates 1160 at the corresponding ends. An even number of thermoelectric lines 1600 may be arranged on the sub-substrate 1160. In addition, the thermoelectric elements 1200 belonging to the adjacent sub-substrates 1160 may be connected to each other at the ends where the adjacent sub-substrates 1160 are connected to each other.

Here, a portion where the sub-substrates 1160 are connected to each other will be referred to as a base region of the substrate 1100, and a portion where the sub-substrates 1160 are cut away and spaced apart from each other will be referred to as a wing region of the substrate 1100. In the example of FIG. 46, the base region may be located on one side in the extending direction of the thermoelectric lines 1600 of the substrate 1100, and the wing region may extend from the base region toward the other side in the extending direction of the thermoelectric lines 1600. Thus, the thermoelectric elements 1200 belonging to the adjacent sub-substrates 1160 may be connected to each other in the base region.

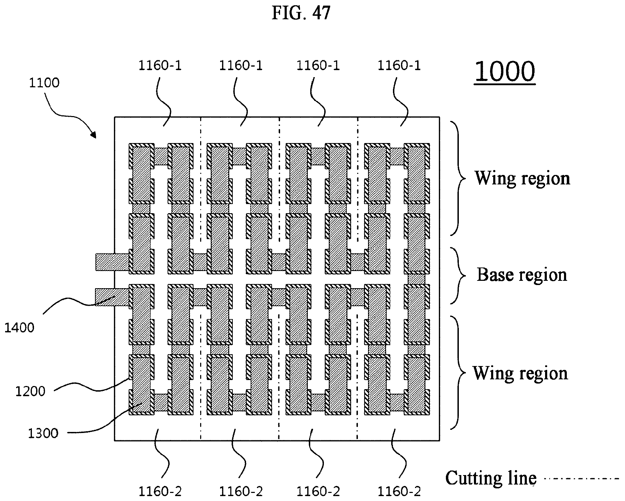

FIG. 47 is a plan view of another embodiment of the sixth example of the flexible thermoelectric module 1000 according to one exemplary embodiment of the present invention.

Referring to FIG. 47, according to another embodiment, the substrate 1100 may include first sub-substrates 1160-1 and second sub-substrates 1160-2 located on both sides of an imaginary line perpendicular to the extending direction of thermoelectric lines 1600. The first sub-substrates 1160-1 may be arranged in a direction perpendicular to the extending direction of the thermoelectric lines 1600, and the second sub-substrates 1160-1 may also be arranged in a direction perpendicular to the extending direction of the thermoelectric lines 1600. An even number of thermoelectric lines 1600 may be arranged on the sub-substrate 1160. In addition, the thermoelectric elements 1200 belonging to the adjacent first sub-substrates 1160-1 may be connected to each other at a portion where the first sub-substrates 1160-1 are connected. Similarly, the thermoelectric elements 1200 belonging to the adjacent second sub-substrates 1160-2 may be connected to each other at a portion where the second sub-substrates 1160-2 are connected.

In the example of FIG. 47, the base region of the substrate 1100, which is a portion where the sub-substrates 1160 are connected to each other, may be formed along the imaginary line, and the wing regions, which are portions where the sub-substrates 1160 are cut and spaced apart from each other, may extend from the base region in both directions. Therefore, the connection between the thermoelectric elements 1200 belonging to the adjacent first sub-substrates 1160-1 and the connection between the thermoelectric elements 1200 belonging to the adjacent second sub-substrates 1160-2 may be made in the base region. A terminal 1400 connected to a thermoelectric element 1200 belonging to the first sub-substrate 1160-1 and a terminal 1400 connected to a thermoelectric element 1200 belonging to the second sub-substrate 1160-2 may be provided at one end of the base region. In addition, a thermoelectric element 1200 belonging to the first sub-substrate 1160-1 may be connected to a thermoelectric element 1200 belonging to the second sub-substrate 1160-2 at the other end of the base region.

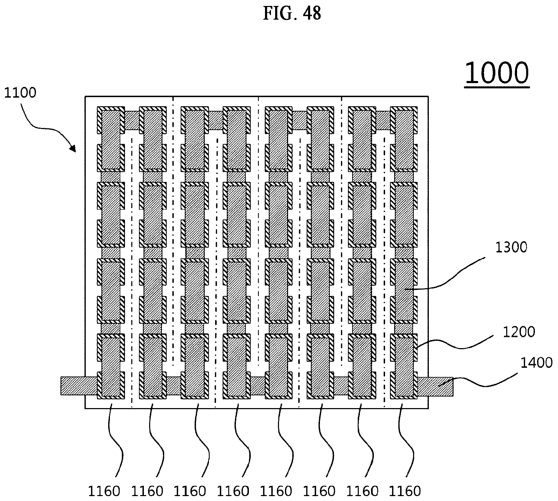

FIG. 48 is a plan view of still another embodiment of the sixth example of the flexible thermoelectric module 1000 according to one exemplary embodiment of the present invention.

Referring to FIG. 48, according to still another embodiment, the sub-substrates 1160 may be connected to one of two sub-substrates 1160 adjacent thereto at one of both ends along the extending direction of the thermoelectric lines 1600 and be connected to the other one of the two sub-substrates 1160 adjacent thereto at the other end. Of course, the outermost sub-substrates 1160 of the sub-substrates 1160 may be connected to the terminal 1400 instead of an adjacent sub-substrate 1160 at the corresponding ends. An odd number of thermoelectric lines 1600 may be arranged on the sub-substrate 1160. In addition, the thermoelectric elements 1200 belonging to the adjacent sub-substrates 1160 may be connected to each other at the end where the adjacent sub-substrates 1160 are connected.

The flexible thermoelectric module 1000 is configured by a combination of the sub-substrates 1160 shown in FIGS. 46 and 48. Specifically, the substrate 1100 may be configured in a manner in which a part of the sub-substrates 1160 is connected to sub-substrates 1160 adjacent thereto at one end and the other part is connected to sub-substrates 1160 adjacent thereto at both ends.

In the case of the flexible thermoelectric module 1000 having the substrate 1100 compartmentalized into the plurality of sub-substrates 1100 described above, the sub-substrates 1100 are cut away from each other, and therefore the spacing between the sub-substrates 1100 may be relatively freely adjusted. Accordingly, the problems such as folding or tension that occur when the flexible thermoelectric module 1000 composed of the substrate 1100 of a flat plate shape is attached to a complex curved surface may be addressed.

Moreover, when the flexible thermoelectric module 1000 is curved, the main surface of the flexible thermoelectric module 1000 is not curved as a whole. Instead, the sub-substrates 1160 partitioning the substrate 1100 are individually curved. Therefore, the flexible thermoelectric module 1000 may secure a higher flexibility.

Thus, an advantage of the flexible thermoelectric module 1000 having the substrate 1100 cut and compartmentalized into a plurality of sub-substrates 1160 as described above may be that it can be easily attached to a complex curved shape.

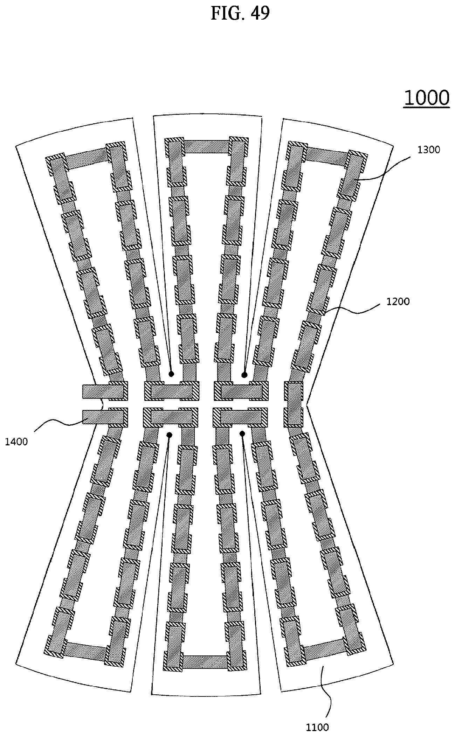

FIG. 49 shows a modification of one embodiment of the sixth example of the flexible thermoelectric module 1000 according to one exemplary embodiment of the present invention.

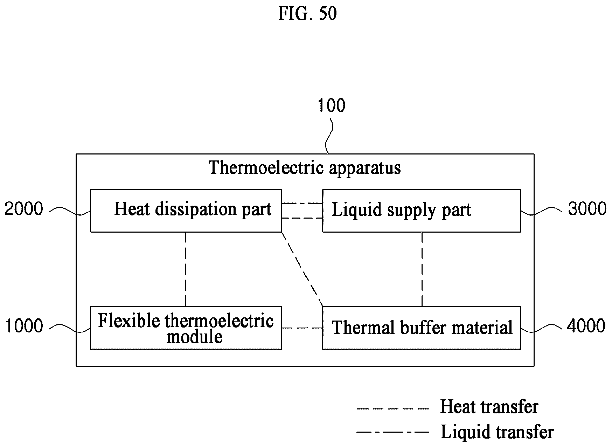

FIG. 49 is a variation of the flexible thermoelectric module 1000 having the substrate 1100 including the base region and the wing regions extending from the base region to both sides shown in FIG. 47. The flexible thermoelectric module 1000 shown in FIG. 47 has a width that does not change but is constant along the direction in which the wing region extends from the connection region, whereas the flexible thermoelectric module 1000 shown in FIG. 50 has a width that changes along a direction in which the wing region extends from the connection region. Herein, the width may be defined as a distance between two edges of the substrate 1100 located at both ends of the direction perpendicular to the extending direction of the thermoelectric line 1600.

In the case where the width of the substrate 1100 of the flexible thermoelectric module 1000 is constant as shown in FIG. 47, it may be difficult to attach the flexible thermoelectric module to a surface whose curvature varies, particularly, a complex curved surface having two or more radii of curvature such as a rim which is spherical and has a circular cross-section, although the sub-substrates 1160 are cut away from each other. In contrast, in the case where the width of the substrate 1100 of the flexible thermoelectric module 1000 changes as shown in FIG. 50, it may be easy to attach the flexible thermoelectric module to a surface whose curvature varies.

For example, the grip portion 602 of the thermoelectric apparatus 100 such as the steering wheel 600 shown in FIG. 45 has a circular or elliptical cross section and has a rim shape as a whole. Thus, the surface thereof is a complex curved surface having multiple radii of curvature. A flexible thermoelectric module 1000 manufactured using a simple flat plate-shaped substrate 1100 cannot be attached to the above-described complex curved surface without being wrinkled or torn. Unlike the flexible thermoelectric module 1000 using a non-cut substrate 1100, the flexible thermoelectric module 1000 using the substrate 1100 of FIG. 47 compartmentalized into a plurality of sub-substrates 1160 by cutting the substrate 1100 may be deformed into a complex curved surface to a certain extent. However, in this process, the base region may be slightly warped or wrinkled. On the other hand, the flexible thermoelectric module 1000 whose width changes along the extending direction of the wing region as shown in FIG. 49 may be easily deformed into a complex curved shape of the thermoelectric apparatus 100 of FIG. 45.

Specifically, referring again to FIG. 45, when it is assumed that a portion on which the flexible thermoelectric module 1000 is to be installed is positioned at a certain angle from the center line of the rim, the length of the inner circumferential line of the portion, which is on a side close to the center of the rim, is less than the length of the outer circumferential line of the portion, which is on a side far from the center of the rim. Considering this point, a portion of the substrate 1100 to be positioned on the inner circumferential line when the thermoelectric lines 1600 of the flexible thermoelectric module 1000 are arranged along a curved surface extending from the inner circumferential line to the outer circumferential line may be designed to be narrow, and a portion of the substrate to be positioned on the outer circumferential line may be designed to be wide. The flexible thermoelectric module 1000 of FIG. 50 includes a substrate 1100 whose width gradually increases along a direction extending from the base region to the wing region. Accordingly, the flexible thermoelectric module 1000 of FIG. 49 may be deformed into a complex curved surface such that the base region is positioned at the inner circumferential line and the wing regions extend from the inner circumferential line to the outer circumferential line. Thereby, the flexible thermoelectric module may surround the grip portion of the rim.

All the examples described above may be used in combination with other embodiments. In other words, the flexible thermoelectric modules 1000 according to the present embodiment, that is, the flexible thermoelectric module 1000 having the arrangement of the thermoelectric elements 1200 and the electrodes 1300 in consideration of the layer structures or the curving direction described above, the flexible thermoelectric module 1000 having connector electrodes 1300a arranged on the same side, the flexible thermoelectric module 1000 having an arrangement of connectors 1400 and connector electrodes 1300a in consideration of a radius of curvature, the flexible thermoelectric module 1000 having a connection region arranged at the center of the main surface, and the flexible thermoelectric module 1000 used for a complex curved surface may be used individually or in combination of two or more thereof.

### 8. Thermoelectric apparatus with improved waste heat release performance and improved cold sensation provision performance

FIG. 50 is a block diagram of configuration of a thermoelectric apparatus 100 according to one exemplary embodiment of the present invention.

Referring to FIG. 50, the thermoelectric apparatus 100 may include a flexible thermoelectric module 1000 as described above, a heat dissipation part 2000, a liquid supply part 3000, and a thermal buffer material 4000. Here, the thermal buffer material 4000 may represent a material that absorbs a predetermined amount of heat from the outside of the thermal buffer material 4000 and retains the absorbed heat.

The flexible thermoelectric module 1000 may output thermal feedback. The thermal feedback may be output when the flexible thermoelectric module 1000 including a contact surface contacting the body of a user and thermoelectric elements connected to the contact surface applies warmth or coldness, which is generated in the thermoelectric elements, to the body of the user through the contact surface as power is applied to the flexible thermoelectric module. In the embodiment of the present invention, the flexible thermoelectric module 1000 may output the thermal feedback by performing a heat generation operation, a heat absorption operation, or a heat grilling operation according to a thermal feedback signal received from an external device different from the thermoelectric apparatus 100 via a communication module (not shown) configured to communicate with the external device. Further, when a temperature difference is generated around the flexible thermoelectric module 1000, an electromotive force may be generated, and the flexible thermoelectric module 1000 may provide power using the electromotive force.

The heat dissipation part 2000 may represent an element configured to release waste heat generated in the flexible thermoelectric module 1000 to the outside of the thermoelectric apparatus 100. Here, the waste heat may refer to remaining heat excluding the heat used to provide a thermal experience to the user from the heat generated by the thermoelectric apparatus 100. For example, residual heat remaining in the thermoelectric apparatus 100 after thermal feedback is output by the flexible thermoelectric module 1000 may be included in the waste heat.

The liquid supply part 3000 may represent an element configured to release waste heat in the form of latent heat in the heat dissipation part 2000. In the embodiment of the present invention, the liquid supply part 3000 may supply a liquid to the heat dissipation part 2000. The liquid supplied to the heat dissipation part 2000 may be vaporized by the waste heat transferred from the flexible thermoelectric module 1000. A larger amount of waste heat may be released to the outside due to the vaporization. In addition, the temperature of the thermoelectric apparatus 100 may be lowered due to the vaporization. For example, the evaporated liquid may take heat from the liquid that is supplied to the heat dissipation part 2000 but is not evaporated. Thereby, the temperature of the liquid that is supplied to the heat dissipation part 2000 but is not evaporated may be lowered.

As the thermal buffer material 4000 absorbs and retains a predetermined amount of heat, the degree to which the waste heat degrades the user's thermoelectric experience may be reduced for the time for which the waste heat is additionally absorbed by the thermal buffer material 4000. In addition, the amount of coldness transferred to the user may be increased.

In an embodiment of the present invention, the thermal buffer material 4000 may be provided in various forms. For example, the thermal buffer material 4000 may be provided in an independent material form. As an example, the thermal buffer material 4000 may be arranged in the form of a plurality of independent materials in some areas of the heat dissipation part 2000. As another example, the thermal buffer material 4000 may be provided in the form of a layer. For example, the thermal buffer material 4000 may be arranged in the form of a layer on at least one surface of the flexible thermoelectric module 1000, the heat dissipation part 2000, or the liquid supply part 3000.

Of course, the thermal buffer material 4000 may be provided in any form that can be included in the thermoelectric apparatus 100 other than the independent material or layer form. In one embodiment, the thermal buffer material 4000 may be separated from the thermoelectric apparatus 100. In one example, the thermal buffer material 4000 may be separated from the thermoelectric apparatus 100 and replaced with another thermal buffer material. In another example, when the thermal buffer material 4000 absorbs heat, the thermal buffer material 4000 may be separated from the thermoelectric apparatus 100 to release the absorbed heat to the outside of the thermoelectric apparatus 100.

In an embodiment of the present invention, the thermal buffer material 4000 may be a phase change material (PCM). The PCM is a material having a large heat of fusion. The PCM may store or release a large amount of energy by melting or hardening at a certain temperature. In one embodiment, the PCM may store or release heat through chemical bonding. For example, in the case where the PCM is a material whose phase changes from solid to liquid, the temperature of the PCM increases when heat is applied to the PCM that is in the solid state. When the temperature of the PCM reaches the melting point or a transition temperature of the PCM, the PCM continues to absorb heat without increase in temperature of the PCM. At this time, phase change of the PCM from solid to liquid occurs. Thereafter, when no heat is applied to the PCM, the PCM releases the accumulated heat to the outside. Then, the phase of the PCM may return from liquid to solid. Thus, the temperature of the PCM increases from an initial temperature to the transition temperature. However, once the PCM reaches the transition temperature, the temperature of the PCM does not increase anymore until the phase change is completed. Every PCM may have a unique transition temperature. When the PCM constitutes the thermal buffer material 4000, the transition temperature of the PCM may need to be included in a temperature change range of the inside of the thermoelectric apparatus 100. When the transition temperature of the PCM is not included in the temperature change range of the inside of the thermoelectric apparatus 100, phase change of the PCM may not occur even when waste heat is accumulated inside the thermoelectric apparatus 100. Then, the temperature of the PCM may continuously increase, and the PCM may not function as the thermal buffer material 4000. For example, the transition temperature of the PCM may be between 5 °C and 60 °C or between 20 °C and 40 °C.

In an embodiment of the present invention, the PCM used for the thermal buffer material 4000 may be composed of various materials. For example, the PCM may include hydrated inorganic salts including hydrated calcium chloride, lithium nitrogen oxide, and hydrated sodium sulfate, polyhydric alcohols including dimethyl propanediol (DMP), hexamethyl propanediol (HMP), xylitol, and erythritol and include linear chain hydrocarbons including polyethylene terephthalate (PET)-polyethylene glycol (PEG) copolymer, PEG, polytetramethyl glycol (PTMG), and paraffin.

Further, in an embodiment of the present invention, the PCM used for the thermal buffer material 4000 may be implemented in various forms. For example, the PCM may be included in a microcapsule or may be implemented by filling a fabric with the PCM or by coating.

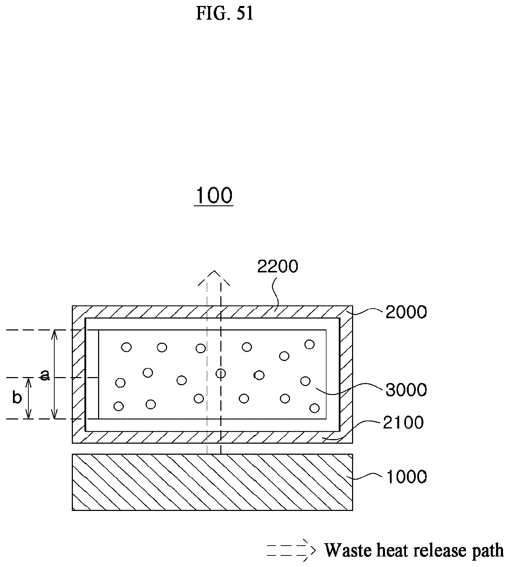

FIG. 51 is a view showing a structure of a feedback device according to one exemplary embodiment of the present invention.

Referring to FIG. 51, which is a cross-sectional view of the thermoelectric apparatus 100 according to one exemplary embodiment of the present invention, the flexible thermoelectric module 1000 and the heat dissipation part 2000 may be stacked in this order in the thermoelectric apparatus 100, and the liquid supply part 3000 may be arranged inside the heat dissipation part 2000. Here, the lower surface of the flexible thermoelectric module 1000 may be in direct or indirect contact with the user to provide thermal feedback to a user. For example, in the case where the feedback device is a wristband-type wearable device, the flexible thermoelectric module 1000 may be positioned at a portion of the wearable device which comes into contact with the user when the user wears the wearable device. The heat dissipation part 2000 may be positioned in a portion of the wearable device which does not come into contact with the user. A portion of the heat dissipation part 2000 to which the waste heat is transferred may be a heat transfer part 2100 (for example, the lower surface and the side surface of the heat dissipation part 2000), and a portion of the heat dissipation part 2000 where waste heat is taken in the form of latent heat through evaporation may be a heat release part 2200 (for example, the upper surface of the heat dissipation part 2000).

In one exemplary embodiment of the present invention, a liquid obstruction material (for example, a waterproof membrane, a waterproof film) may be arranged between the liquid supply part 3000 and the flexible thermoelectric module 1000 to prevent the liquid from being transferred from the liquid supply part 3000 to the flexible thermoelectric module 1000.

In the embodiment of the present invention, when the flexible thermoelectric module 1000 performs the heat absorption operation, cold heat energy may be transferred to the lower surface of the flexible thermoelectric module 1000, and hot heat energy may be transferred to the upper surface of the thermoelectric module 1000. The hot heat energy may be waste heat that hinders the user's thermal experience. In this case, the waste heat may be transferred from the thermoelectric module 1000 to the heat release part 2200 through the heat transfer part 2100 and the liquid supply part 3000 and be released from the heat release part 2200. That is, the waste heat transfer path may be formed along the flexible thermoelectric module 1000, the heat transfer part 2100, the liquid supply part 3000, and the heat release part 2200. Here, the liquid supply part 3000 may supply a liquid contained in the liquid supply part 3000 to the heat release part 2200. The liquid supplied from the liquid supply part 3000 may evaporate on the heat release part 2200 due to the waste heat. As the liquid evaporates, the waste heat may be released to the outside of the thermoelectric apparatus 100.

Further, in the embodiment of the present invention, the heat release part 2200 may tend to transfer the liquid in a specific direction depending on the material thereof. For example, the heat release part 2200 may tend to transfer the liquid in the vertical direction or in the lateral direction. In the embodiment of the present invention, the liquid may be transferred to the heat release part 2200 at the lower end of the heat release part 2200. Thus, in the embodiment of the present invention, it may be advantageous for the heat release part 2200 to tend to transfer the liquid in the vertical direction so as to improve the waste heat release performance.

Further, in the embodiment of the present invention, the heat release part 2200 may tend to cause evaporation in a specific direction depending on the material thereof. For example, the heat release part 2200 may tend to cause evaporation upward or laterally. In the embodiment of the present invention, the liquid may evaporate into the air at the upper end of the heat release part 2200. Thus, in the embodiment of the present invention, it may be advantageous for the heat release part 2200 to tend to cause evaporation upward so as to improve the waste heat release performance.

In addition, in the structure according to the embodiment of the present invention, the length of the waste heat transfer path may vary depending on the thickness of the liquid supply part 3000. For example, in the example of FIG. 51, the waste heat transfer path formed when the thickness of the liquid supply part 3000 is b may be shorter than the waste heat transfer path formed when the thickness of the liquid supply part 3000 is a. As the waste heat transfer path is shortened, the time during which the waste heat stays in the liquid supply part 3000 may be shortened, whereby the waste heat release performance of the thermoelectric apparatus 100 may be improved.

In one embodiment, when the thickness of the liquid supply part 3000 is reduced, the amount of liquid contained in the liquid supply part 3000 may be reduced. When the liquid in the liquid supply part 3000 is depleted, the liquid needs to be replenished. As the thickness of the liquid supply part 3000 is reduced, the depletion time of the liquid may also be shortened. That is, depending on the thickness of the liquid supply part 3000, the waste heat release performance of the feedback device 1000 and the liquid retaining performance of the liquid supply part 3000 may be in a trade-off relationship.

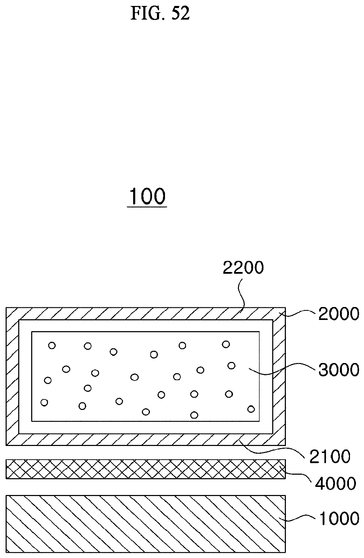

FIG. 52 is a view showing a structure of the feedback device to which a thermal buffer material is applied according to one exemplary embodiment of the present invention is applied.

Referring to FIG. 52, the flexible thermoelectric module 1000 and the heat dissipation part 2000 may be stacked in this order in the thermoelectric apparatus 100, and the liquid supply part 3000 may be arranged inside the heat dissipation part 2000. Here, the thermal buffer material 4000 may be arranged between the heat dissipation part 2000 and the flexible thermoelectric module 1000. Here, the thermal buffer material 4000 may be implemented in the form of a layer. In addition, the heat dissipation part 2000 may include a heat transfer part 2100 and a heat release part 2200. The waste heat transfer path may be formed along the flexible thermoelectric module 1000, the thermal buffer material 4000, the heat transfer part 2100, the liquid supply part 3000, and the heat release part 2200.

In the embodiment of the present invention, since the thermal buffer material 4000 is arranged between the flexible thermoelectric module 1000 and the heat transfer part 2100, the amount of waste heat accumulated in the thermoelectric apparatus 100 for a predetermined time may be reduced and the transfer of the waste heat from the flexible thermoelectric module 1000 to the heat transfer part 2100 may be delayed. As a specific example, when the flexible thermoelectric module 1000 performs the heat absorption operation, waste heat may be generated in the flexible thermoelectric module 1000. When the generated waste heat is transferred to the thermal buffer material 4000, although the temperature of the thermal buffer material 4000 may be raised to the transition temperature by the waste heat, the thermal buffer material 4000 may be maintained at the transition temperature until the phase change of the thermal buffer material 4000 is completed. While the thermal buffer material 4000 is maintained at the transition temperature, waste heat may not be accumulated in the thermoelectric apparatus 100 since the thermal buffer material 4000 absorbs the waste heat. In addition, waste heat having a temperature higher than the transition temperature may not be transferred from the thermal buffer material 4000 to the heat transfer part 2100. Thereafter, only when the phase change of the thermal buffer material 4000 is completed, may waste heat having a temperature higher than the transition temperature be additionally accumulated in the thermoelectric apparatus 100 and transferred to the heat transfer part 2100. Thus, the amount of waste heat inside the thermoelectric apparatus 100 while the thermal buffer material 4000 is maintained at the transition temperature may be smaller than when the thermal buffer material 4000 is not included. As the influence that the waste heat has on the user's thermal experience while the transition temperature is maintained is reduced, the cold sensation providing performance of the thermoelectric apparatus 100 may be improved.

The description above is merely illustrative of the technical idea of the present invention and various modifications and variations can be made by those skilled in the art without departing from the essential characteristics of the present invention. Therefore, the embodiments of the present invention described above may be implemented separately or in combination.

Therefore, the embodiments disclosed in the present invention are intended to illustrate rather than limit the technical spirit of the present invention, and the scope of the technical idea of the present invention is not limited by these embodiments. The scope of protection of the present invention shall be construed on the basis of the accompanying claims in such a manner that all of the technical ideas included within the scope equivalent to the claims belong to the present invention.

### [CLAUSES]

[Clause 1]
   A flexible thermoelectric module used in a curved shape, the module comprises:
   a substrate provided in a plate shape deformable into a curved shape;
   a plurality of thermoelectric elements including an N-type semiconductor and a P-type semiconductor arranged to form a two-dimensional array on the substrate; and
   a plurality of electrodes connecting the N-type semiconductor and the P-type semiconductor,
   wherein the plurality of thermoelectric elements are sequentially connected by the electrodes and forms a thermoelectric line including the thermoelectric elements forming a line shape, and
   wherein an extending direction of the thermoelectric line is closer to a direction perpendicular to a curving direction than the curving direction for being deformed into the curved shape.
[Clause 2]
   The module according to clause 1, wherein the extending direction of the thermoelectric line is perpendicular to the curving direction.
[Clause 3]
   The module according to clause 1, wherein the thermoelectric line is plural, and
   wherein an arrangement direction among the plurality of thermoelectric lines is coincident with the curving direction.
[Clause 4]
   A flexible thermoelectric module used in a curved shape, the module comprising:
   a substrate provided in a plate shape deformable into a curved shape;
   a plurality of thermoelectric elements including an N-type semiconductor and a P-type semiconductor arranged to form a two-dimensional array on the substrate;
   a first electrode connecting the N-type semiconductor and the P-type semiconductor along a first direction; and
   a second electrode connecting the N-type semiconductor and the P-type semiconductor along a second direction perpendicular to the first direction,
   wherein a curving direction for being deformed into the curved shape coincides with a direction along which one of the first electrode and the second electrode that is smaller in number connects the N-type semiconductor and the P-type semiconductor.
[Clause 5]
   A flexible thermoelectric module used in a curved shape, the module comprises:
   a substrate provided in a plate shape deformable into a curved shape;
   a plurality of thermoelectric elements including an N-type semiconductor and a P-type semiconductor arranged to form a two-dimensional array on the substrate;
   a first electrode connecting the thermoelectric element sequentially along a first direction to form a thermoelectric line; and
   a second electrode connecting the thermoelectric element along a second direction perpendicular to the first direction to form an electrical connection between the thermoelectric line,
   wherein the second direction is closer to a curving direction for being deformed into the curved shape than the first direction.
[Clause 6]
   The module according to clause 5, wherein the first direction is perpendicular to the curving direction, and the second direction is coincident with the curving direction.
[Clause 7]
   A flexible thermoelectric module used in a curved shape, the module comprising:
   a substrate provided in a plate shape deformable into a curved shape;
   a plurality of thermoelectric elements forming a two-dimensional array on the substrate, provided in a columnar shape, and including a N-type semiconductor and a P-type semiconductor, and
   a plurality of electrodes electrically connecting the plurality of thermoelectric elements along a length direction thereof,
   wherein the plurality of thermoelectric elements are electrically connected to the substrate and form a thermoelectric line extending in one direction, and
   wherein the thermoelectric line is arranged in a direction perpendicular to a curving direction for being deformed into the curved shape to minimize deformation of an electrode connecting thermoelectric elements belonging to the thermoelectric line when deformed into the curved shape.
[Clause 8]
   The module according to clause 7, wherein the electrode is arranged on one side of the substrate to face the plurality of thermoelectric elements, provided in a plate shape having a length dimension larger than a width dimension, and electrically connects the plurality of thermoelectric elements by both ends along a length direction of the electrodes contacting with a N-type semiconductor and a P-type semiconductor which are adjacent respectively to each of the both ends.
[Clause 9]
   The module according to clause 7, wherein a plurality of thermoelectric lines are arranged along the curving direction on the substrate,
   wherein thermoelectric lines electrically connected among the plurality of thermoelectric lines form a thermoelectric group, and
   wherein an electrode among the electrodes forming the electrical connection between thermoelectric lines constituting the thermoelectric group is arranged so that a length direction thereof is coincident with the curving direction.
[Clause 10]
   A flexible thermoelectric module used in a curved shape, the module comprising:
   a substrate provided in a plate shape and deformable into a curved shape;
   a plurality of thermoelectric lines formed by electrically connecting a plurality of thermoelectric elements arranged in a line; and
   a first electrode having a length direction arranged along the extending direction of the thermoelectric line and connecting thermoelectric elements belonging to the same thermoelectric line and a second electrode having a length direction arranged along the arrangement direction of the thermoelectric line and connecting thermoelectric elements between adjacent thermoelectric lines,
   wherein a length direction of one of the first electrode and the second electrode which is smaller in number coincides with a curving direction for being deformed into the curved shape.
[Clause 11]
   The module according to clause 10, wherein a length direction of the second electrode is coincident with the curving direction.
[Clause 12]
   The module according to clause 10, wherein the second electrode is arranged on the same main surface of the substrate in both edge regions of the substrate opposite to each other along the extending direction of the thermoelectric line.

## Claims

1. A flexible thermoelectric module, comprising:
a substrate having a base region and a plurality of wing regions extended from the base region, wherein the plurality of wing regions comprise a first wing region extended along a first direction and a second wing region extended along a second direction;
two terminals disposed on the substrate and configured to receive an electrical power;
a plurality of thermoelectric elements disposed on the substrate; and
a plurality of electrodes disposed on the substrate and configured to connect the two terminals and the plurality of thermoelectric elements for providing the electrical power to the plurality of thermoelectric elements,
wherein the plurality of thermoelectric elements comprise a first set of thermoelectric elements, a second set of thermoelectric elements and a third set of thermoelectric elements,
wherein the first set of thermoelectric elements are disposed on the substrate along the first direction so as to form a first thermoelectric line,
wherein the second set of thermoelectric elements are disposed on the substrate along the first direction so as to form a second thermoelectric line,
wherein the third set of thermoelectric elements are disposed on the substrate along the second direction so as to form a third thermoelectric line,
wherein the plurality of electrodes comprise a first electrode and a second electrode,
wherein the first electrode is disposed on the first wing region and electrically connects the first thermoelectric line and the second thermoelectric line, and
wherein the second electrode is disposed on the base region and electrically connects the second thermoelectric line and the third thermoelectric line.

2. The flexible thermoelectric module of claim 1,
wherein a deformation of the first wing region is independent from a deformation of the second wing region.

3. The flexible thermoelectric module of claim 1,
wherein the two terminals and the plurality of thermoelectric elements are serially connected via the plurality of electrodes.

4. The flexible thermoelectric module of claim 1,
wherein the first wing region has a first edge adjacent to the second wing region and the second wing region has a second edge adjacent to the first wing region, and
wherein a gap between the first edge and the second edge is maintained along the first edge or the second edge.

5. The flexible thermoelectric module of claim 1,
wherein the first wing region has a first edge adjacent to the second wing region and the second wing region has a second edge adjacent to the first wing region, and
wherein a gap between the first edge and the second edge is changed along the first edge or the second edge.
